(19) Europäisches Patentamt
European Patent Office
Office européen des brevets

(11) **EP 2 015 358 B1**

(12) **FASCICULE DE BREVET EUROPEEN**

(45) Date de publication et mention
de la délivrance du brevet:
**30.11.2011 Bulletin 2011/48**

(21) Numéro de dépôt: **08159884.9**

(22) Date de dépôt: **08.07.2008**

(51) Int Cl.:
*H01L 21/8244* *(2006.01)*  *H01L 27/11* *(2006.01)*
*G11C 14/00* *(2006.01)*  *G11C 23/00* *(2006.01)*
*H01L 29/51* *(2006.01)*  *H01L 27/20* *(2006.01)*
*H01L 41/09* *(2006.01)*  *H01L 21/28* *(2006.01)*
*H01L 21/336* *(2006.01)*  *H01L 29/423* *(2006.01)*
*H01L 29/68* *(2006.01)*  *H01L 29/78* *(2006.01)*
*B81B 3/00* *(2006.01)*  *B81B 7/02* *(2006.01)*
*H01L 29/49* *(2006.01)*

(54) **Cellule mémoire SRAM non-volatile dotée de transistors à grille mobile et actionnement piézoélectrique**

Nichtflüchtige SRAM-Speicherzelle mit Transistoren mit beweglichem Gate und piezoelektrischer Betätigung

Non-volatile SRAM memory cell with mobile-gate transistors and piezoelectric activation

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **09.07.2007 FR 0756348**

(43) Date de publication de la demande:
**14.01.2009 Bulletin 2009/03**

(73) Titulaire: **Commissariat à l'Énergie Atomique et aux Énergies Alternatives**
**75015 Paris (FR)**

(72) Inventeurs:
• **Thomas, Olivier**
**38420 Revel (FR)**
• **Collonge, Michael**
**38600 Fontaine (FR)**
• **Vinet, Maud**
**38140 Rives (FR)**

(74) Mandataire: **Ilgart, Jean-Christophe**
**BREVALEX**
**95 rue d'Amsterdam**
**75378 Paris Cedex 8 (FR)**

(56) Documents cités:
**US-A- 4 435 786**     **US-A- 5 757 696**
**US-A1- 2003 042 528**     **US-A1- 2006 284 239**

**Description**

**DOMAINE TECHNIQUE**

L'invention se rapporte au domaine des mémoires à accès aléatoire statique (SRAM pour « static random access memory ») et à celui des mémoires non-volatiles. Elle concerne en particulier une structure de cellule mémoire SRAM non-volatile comportant des transistors à tension de seuil modulable, en particulier dotés d'une grille mobile et de moyens d'actionnement piézoélectriques aptes à moduler la position de la grille et à maintenir une position de la grille après extinction de l'alimentation des transistors. Une telle cellule mémoire peut allier les performances, en termes de consommation et d'encombrement, d'une cellule SRAM conventionnelle, ainsi que les qualités de maintien de l'information stockée d'une cellule non-volatile. Une réalisation avantageuse de la cellule, permet d'obtenir une stabilité en lecture améliorée et une consommation statique diminuée.

**ÉTAT DE LA TECHNIQUE ANTÉRIEURE**

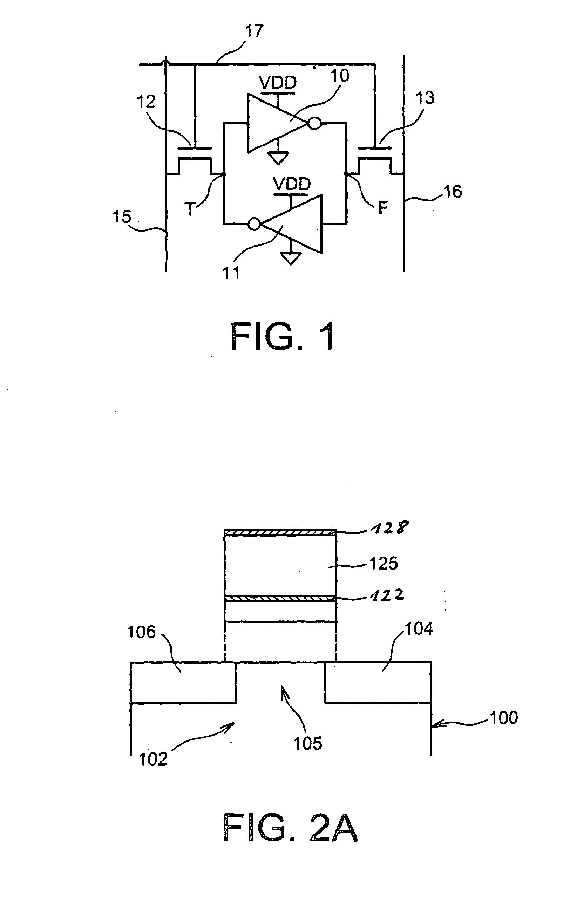

Une cellule mémoire SRAM classique (SRAM pour « Static Random Access Memory » ou mémoire vive statique) comprend généralement deux inverseurs 10, 11, connectés selon une configuration dite « de bascule » ou « flip-flop » et deux transistors d'accès 12, 13 connectés à des lignes dites de bit 15 et 16, et commandés par une ligne de mot 17 (figure 1).

Les caractéristiques recherchées pour une cellule mémoire sont :

- une bonne stabilité lors des différentes opérations de lecture, d'écriture, de rétention, appréciées respectivement à l'aide d'un facteur de stabilité en lecture (SNM), d'un facteur de marge en écriture (WM), d'un facteur de stabilité en rétention (RNM),
- un courant de conduction ($I_{CELL}$) ou de charge le plus important possible pour donner à la cellule une vitesse de fonctionnement élevée,
- une taille de cellule la plus faible possible pour permettre de réaliser une mémoire avec une densité d'intégration de cellules importante,
- un courant en rétention ($I_{OFF}$) le plus faible possible afin de minimiser la puissance consommée statique.

Ces critères sont difficiles à concilier et amènent les concepteurs de mémoires à faire des compromis.

En cherchant à réduire de plus en plus les tailles des transistors des cellules mémoires, les paramètres de ces transistors fluctuent. Cela entraîne, comme indiqué dans les documents [TAK01] et [YAM04] (référencés à la fin de la présente description au même titre que tous les autres documents cités dans la présente demande), une augmentation de la sensibilité des cellules mémoires face aux différentes sources de bruit telles que le couplage capacitif, le couplage

inductif, le bruit d'alimentation. Les marges en écriture et en lecture sont de plus en plus faibles, ce qui limite la possibilité de réduire la surface des cellules mémoire. Le document US 2006/0284239 A1 présente une cellule de mémoire flash dotée de transistors à grille actionnée par des moyens piézoélectriques et comportant une grille flottante. Les documents US5757696, US4435786 et US20030042528 divulguent des mémoires de type SRAM comprenant des transistors à grille flottante.

Par ailleurs, le développement de plus en plus important des applications multimédias, entraine le besoin de mettre en oeuvre des circuits mémoire non-volatiles aux performances améliorées. Parmi les mémoires non-volatiles existantes on compte par exemple les mémoires de type FLASH, de type PCM (PCM pour « Phase-Change Memory » ou mémoire à changement de phase). Le document [NAT"05] présente par exemple différents type de cellules mémoires non-volatiles existantes.

L'inconvénient principal des mémoires non-volatiles actuelles réside dans leurs performances insuffisantes en termes de vitesse de lecture et d'écriture.

Il se pose le problème de trouver une nouvelle structure de cellule mémoire, non-volatile, qui présentant une stabilité et des performances électriques et un encombrement équivalent ou améliorés par rapport à une mémoire SRAM classique.

**EXPOSÉ DE L'INVENTION**

L'invention est définie par la cellule de mémoire suivant la revendication 1. La présente invention concerne une cellule de mémoire vive non-volatile à accès aléatoire, comprenant : au moins une première pluralité de transistors formant une bascule, les transistors de la première pluralité de transistors comportant respectivement : un diélectrique de grille et une grille mobile, suspendue au-dessus et disjointe du diélectrique de grille, la grille étant située à une distance ajustable de ladite zone de diélectrique de grille, les transistors étant en outre surmontés de moyens d'actionnement piézoélectriques aptes à déplacer la grille par rapport à ladite zone de canal.

Les moyens d'actionnement piézoélectriques comprennent un empilement formé d'au moins une couche de matériau piézoélectrique reposant sur une première électrode de polarisation, une deuxième électrode de polarisation reposant sur la couche de matériau piézoélectrique.

Selon une possibilité de mise en oeuvre, la grille peut être rattachée à ladite première électrode.

Selon une mise en oeuvre possible de la cellule, la grille peut être en contact avec ladite première électrode.

Selon une mise en oeuvre possible, les transistors de la première pluralité de transistors peuvent avoir une zone de source connectée à la deuxième électrode de leurs moyens d'actionnement piézoélectriques respectifs.

Selon une variante, les transistors de la première pluralité de transistors peuvent avantageusement avoir leur zone de drain respective connectée à la deuxième électrode de leurs moyens d'actionnement piézoélectriques respectifs.

Des transistors de la première pluralité de transistors sont aptes respectivement à adopter : au moins une première position dans laquelle leur grille est située à une première distance du canal, et à adopter au moins une deuxième position dans laquelle la grille est située à une deuxième distance du canal, différente de la première distance.

La cellule de mémoire vive non-volatile à accès aléatoire peut comprendre en outre des moyens d'alimentation aptes à alimenter les transistors de la première pluralité de transistors, et leurs moyens d'actionnements respectifs. Les transistors de la première pluralité de transistors peuvent être aptes respectivement à adopter une position donnée parmi lesdites première et deuxième positions, et apte en outre à maintenir la grille dans ladite position donnée après arrêt ou extinction desdits moyens d'alimentation.

Les transistors de la première pluralité de transistors sont aptes respectivement à adopter un état dans lequel, les moyens d'actionnement piézoélectriques sont mis dans un état de polarisation donné, et dans lequel la grille est maintenue à l'aide des moyens d'actionnement piézoélectriques en contact avec le diélectrique de grille, les transistors de la première pluralité de transistors étant aptes en outre à adopter un autre état dans lequel les moyens d'actionnement piézoélectriques ne sont pas polarisés, et dans lequel la grille est maintenue par collage électrostatique, en contact avec le diélectrique de grille.

Les transistors de la première pluralité de transistor peuvent avoir une tension de seuil variable, susceptible de varier par déplacement de la grille mobile à l'aide des moyens d'actionnement piézoélectriques.

Selon une possibilité, ladite première pluralité de transistors peut comprendre :

- un premier transistor de charge et un deuxième transistor de charge,
- un premier transistor de conduction et d'un deuxième transistor de conduction.

La cellule de mémoire vive non-volatile à accès aléatoire suivant l'invention est susceptible d'adopter plusieurs modes de fonctionnement dont au moins un mode de rétention d'information contenue dans la cellule, au moins un mode de lecture d'information contenue dans la cellule, et au moins un mode d'écriture d'information dans la cellule, les transistors de la première pluralité de transistor ayant respectivement une tension de seuil variable.

L'invention concerne également une mémoire SRAM, comprenant une pluralité de cellules telles que définies précédemment.

L'invention concerne en outre un dispositif microélectronique doté d'au moins une mémoire SRAM telles que définie précédemment.

**BREVE DESCRIPTION DES DESSINS**

La présente invention sera mieux comprise à la lecture de la description d'exemples de réalisation donnés, à titre purement indicatif et nullement limitatif, en faisant référence aux dessins annexés sur lesquels :

- la figure 1, illustre un exemple de cellule mémoire vive statique suivant l'art antérieur,
- les figures 2A, 2B, illustrent un transistor intégré à une cellule mémoire suivant l'invention et comportant une grille suspendue et des moyens d'actionnement piézoélectriques, aptes à déplacer la grille du transistor par rapport au diélectrique de grille et au canal du transistor,
- les figures 3A, 3B illustrent différentes positions d'un transistor intégré dans une cellule mémoire suivant l'invention, et doté d'une grille mobile suspendue et de moyens d'actionnement piézoélectriques de la grille,
- les figures 4A, 4B, illustrent respectivement des étapes de collement de la grille au diélectrique de grille, et de décollement de la grille du diélectrique de grille, du transistor à grille mobile suspendue et actionnement piézoélectrique intégré à une cellule mémoire suivant l'invention,
- les figures 5A, 5B, illustrent un fonctionnement non-volatile d'un transistor à grille mobile suspendue et actionnement piézoélectrique, intégré dans une cellule mémoire suivant l'invention,
- les figures 6A, 6B, illustrent un procédé de modulation dont les étapes ne font pas partie de l'invention mais illustrent des caractéristiques de dispositif faisant partie de l'invention de la tension de seuil d'un transistor à grille mobile et actionnement piézoélectrique intégré à une cellule mémoire suivant l'invention, tandis que la figure 6C, illustre une caractéristique tension de grille-courant de drain d'un transistor suivant l'invention,

- les figures 7A à 7J, illustrent, selon une vue en coupe, des étapes d'un exemple de procédé de réalisation dont les étapes ne font pas partie de l'invention mais illustrent des caractéristiques de dispositif faisant partie de l'invention d'un dispositif microélectronique selon l'invention, tandis que les figures 8A à 8E illustrent, selon une vue de dessus, des étapes de ce procédé,
- les figures 9A à 9D, illustrent, selon une vue en coupe, des étapes d'une variante de procédé de réalisation dont les étapes ne font pas partie de l'invention mais illustrent des caractéristiques de dispositif faisant partie de l'invention d'un dispositif microélectronique selon l'invention, tandis que les figures 10A à 10C illustrent, selon une vue de dessus, différentes étapes de cette variante de procédé,
- les figures 11A à 11C, illustrent, selon une vue en coupe, des étapes d'une autre variante de procédé de réalisation dont les étapes ne font pas partie de l'invention mais illustrent des caractéristiques de dispositif faisant partie de l'invention d'un dispositif microélectronique selon l'invention, tandis que les figures 12A à 12B illustrent, selon une vue de dessus, des étapes de cette autre variante de procédé,
- la figure 13 illustre un exemple de cellule mémoire SRAM non-volatile suivant l'invention, dotée de transistors à grille suspendue et à actionnement piézoélectrique de la grille,
- la figure 14A représente un transistor à grille suspendue et à actionneur piézoélectrique, dans lequel la zone de source est connectée avec l'électrode supérieure de l'actionneur piézoélectrique,
- la figure 14B illustre un exemple de cellule mémoire 6T suivant l'invention dotée de transistors tels que celui illustré sur la figure 14A,
- la figure 15A représente un transistor à grille suspendue et à actionneur piézoélectrique, dans lequel la zone de drain est connectée avec l'électrode supérieure de l'actionneur piézoélectrique,
- la figure 15B illustre un exemple de cellule mémoire 6T suivant l'invention dotée de transistors tels que celui illustrés sur la figure 14A piézoélectrique,
- la figure 16 illustre une cellule mémoire SRAM suivant l'invention en mode de rétention,
- la figure 17A-17B illustre une phase d'écriture dans une cellule mémoire SRAM suivant l'invention,
- la figure 18 illustre un redémarrage d'une cellule mémoire suivant l'invention et son fonctionnement non-volatile.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

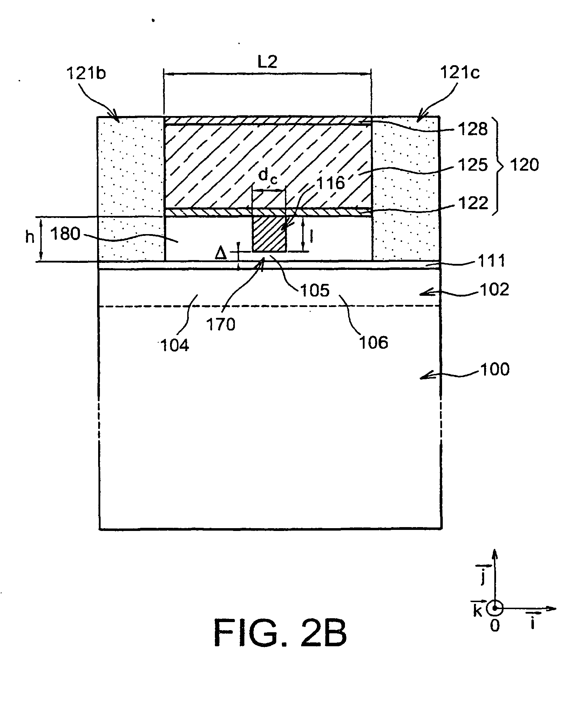

Un exemple de transistor intégré à une cellule mémoire suivant l'invention va à présent être donné en liaison avec les figures 2A et 2B.

Ce transistor repose sur un substrat 100, dans lequel une zone semi-conductrice 102, apte à jouer le rôle de zone active, a été réalisée. La zone semi-conductrice 102 comporte une région de source 104, une région de drain 106, de part et d'autre d'une zone de canal 105 du transistor. Une couche 111 de diélectrique de grille, recouvre la zone semi-conductrice 102. Le transistor comporte une grille 116 suspendue. La grille 116 n'est pas solidaire de, ou n'est pas jointe à, la couche diélectrique 111 de grille.

Le dispositif est apte à adopter au moins une position dans laquelle la grille 116 est située à distance de la couche diélectrique 111 de grille, de sorte qu'un espace existe entre la grille 116 et la couche diélectrique de grille 111. La grille 116 et la couche diélectrique de grille 111, peuvent être séparées d'une distance $\Delta$ (définie sur la figure 2B dans une direction parallèle au vecteur $\vec{j}$ d'un repère orthogonal [0;i;j;k]) modulable ou réglable.

La grille 116 est suspendue ou rattachée par sa face supérieure à des moyens d'actionnement piézoélectriques ou à un actionneur piézoélectrique. La distance entre la grille 116 et le canal 102 peut être modulée à l'aide des moyens d'actionnement piézoélectriques. Les moyens d'actionnement piézoélectriques sont aptes à déplacer la grille 116 par rapport au canal 105 du transistor. La grille 116 est susceptible d'adopter plusieurs positions par rapport au canal 105. Par actionnement piézoélectrique, on entend un déplacement de la grille dû à une déformation de la couche piézoélectrique 125 et de ses électrodes 122, 128 associées, par effet piézoélectrique inverse.

Les moyens d'actionnement piézoélectriques 120 comprennent un empilement 120 formé d'une électrode inférieure 122 à laquelle peut être rattachée la grille 116, une couche de matériau piézoélectrique 125 reposant sur l'électrode inférieure 122, et une électrode supérieure 128 reposant sur la couche de matériau piézoélectrique 125.

Le dispositif peut comporter également un ou plusieurs éléments 121b, 121c, de soutien de l'empilement 120 de l'actionneur piézoélectrique, situés en périphérie de ce dernier (figure 2B). Des plots (non représentés sur les figures 2A-2B) sont également prévus pour réaliser les contacts du transistor. Un ou plusieurs plots conducteurs peuvent être également prévus pour réaliser les contacts de l'actionneur piézoélectrique. Des plots conducteurs peuvent être prévus pour connecter ou relier électriquement respectivement, la zone de source 104 à des moyens de polarisation de la source, la zone de drain 106 à des moyens de polarisation du drain 106, la grille 116 et l'électrode inférieure 122 de l'empilement 120 à des moyens de polarisation de la grille et de l'électrode inférieure 122, l'électrode supérieure 128 de l'actionneur à des moyens de polarisation de l'actionneur piézoélectrique.

Un exemple de fonctionnement d'un dispositif microélectronique suivant l'invention, va être donné en liaison avec les figures 2A-2B, 3A-3B et 4A-4B.

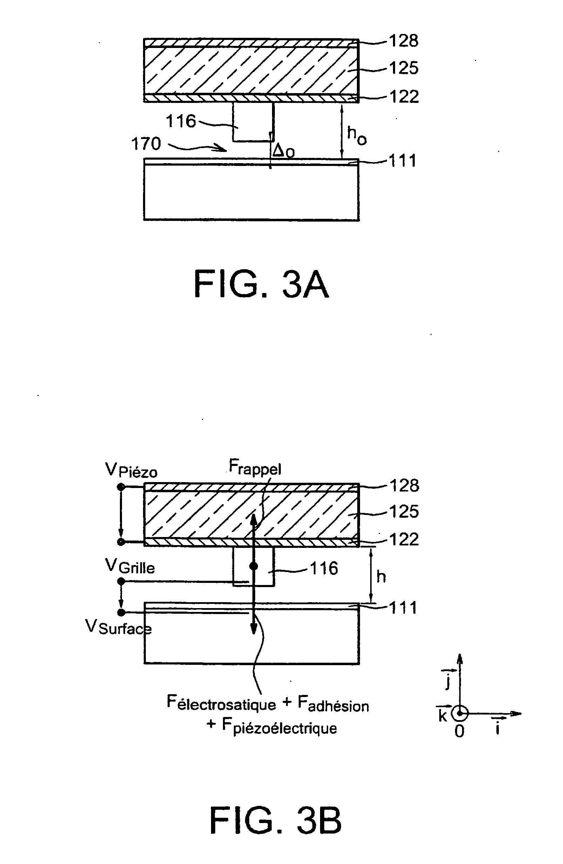

Le dispositif peut adopter une position dite « de repos » dans laquelle l'empilement 120 est suspendu au-dessus et à une hauteur h0 dite « de repos » de la couche de diélectrique 111 de grille. Dans la position de repos, la grille 116 se trouve à une distance $\Delta$0 dite « de repos » du diélectrique 111, de sorte qu'un espace vide 170 se trouve entre la grille 116 et la zone de diélectrique 111 de grille. La couche piézoélectrique 125 peut être plane dans la position de repos. Dans la position de repos, l'alimentation des moyens d'actionnement et du transistor est éteinte, de sorte que toutes les polarisations sont à un potentiel nul (figure 3A).

Lorsqu'ils sont polarisés, les moyens d'actionnement piézoélectriques peuvent actionner la grille 116, et permettre de déplacer cette dernière. Selon la direction du champ électrique extérieur qui lui est appliquée par l'intermédiaire des électrodes 122, 128, cette couche piézoélectrique 125 est apte à se comprimer ou à se détendre, et à déplacer ainsi la grille 116 qui lui est rattachée.

En plus de l'effet piézoélectrique inverse, un effet d'attraction électrostatique résultant de la différence de potentiel entre la grille 116 et le canal 105 du transistor est susceptible d'être mis en oeuvre. Cet effet d'attraction électrostatique se traduit par une force électrostatique tendant à rapprocher la grille 116 du canal 105 du transistor, et qui peut permettre de mettre en contact la grille 116 et le diélectrique 111 de grille.

Une force supplémentaire dite d'adhésion ou également appelée de collage moléculaire peut également être également mise en oeuvre. Un collage moléculaire en particulier de type Van der Waals est susceptible de s'exercer entre la face inférieure de la grille 116 et la surface de diélectrique 111 de grille. La mise en oeuvre de cette force supplémentaire dépend notamment de la planéité de la face inférieure de la grille 116 et de la surface en regard de diélectrique 111 de grille, ainsi que d'un dimensionnement adapté des éléments de la structure. La mise en oeuvre de la force d'adhésion ou de collage moléculaire est décrite par exemple dans les documents suivants : l'article de Asghar Ramezani et al. : « Influence of Van Der Waals Force on the Pull-In Parameters of Cantilever Type Nanoscale Electrostatic Actuators », Microsystem Technologies, 2006, vol. 12, pp. 1153-1161; l'article de W. Merlijn van Spengen et al. : « A Physical Model to Predict Stiction in MEMS », Institute of Physics Publishing, Journal of Micromechanics and Microengineering, 12, (2002), pp.702-713 ; et l'article de Y.-P. ZHAO et al. : « Mechanics of Adhesion in MEMS-a Review », J. Adhesion Sci. TechnoL. Vol. 17, n°4, pp.519-546, 2003. Par rapport aux autres forces auxquelles la grille est soumise, la force d'adhésion ou de collage moléculaire prend d'autant plus d'importance que la grille est proche du diélectrique de grille.

La mise en oeuvre de la force d'adhésion ou de collage moléculaire, permet de conférer au dispositif un fonctionnement non volatile. Ce dernier est susceptible de se maintenir dans une position donnée lors de l'arrêt de l'alimentation et des polarisations de l'actionneur et du transistor. Lorsque les polarisations sont éteintes, la grille 116 est susceptible d'être maintenue en contact du diélectrique 111 de grille. Lorsque le transistor est polarisé à nouveau, il est susceptible d'adopter le même mode de fonctionnement que celui dans lequel il avait été laissé avant l'arrêt des polarisations.

Sur la figure 3B, le dispositif est mis dans un état de polarisation différent de celui de la position de repos et pour lequel le dispositif adopte une première position dans laquelle la grille 116 n'est pas en contact avec la surface de la couche diélectrique 111 de grille, la grille 116 étant maintenue à une distance $\Delta$ non-nulle de la couche diélectrique 111 de grille. Pour que le dispositif adopte la première position, les moyens piézoélectriques sont placés dans un état de polarisation adapté, un potentiel non-nul étant appliqué aux électrodes. La grille 116 suspendue du transistor peut être alors soumise, à quatre forces, dont une première ou force électrostatique $F_{\text{électrostatique}}$ due à la différence de potentiel présente entre la grille et la surface du canal du transistor, une deuxième force ou force piézoélectrique $F_{\text{piézoélectrique}}$, engendrée par la différence de potentiel appliquée entre les deux électrodes 122, 128 de polarisation de la couche piézoélectrique, une troisième force ou force de rappel $F_{\text{rappel}}$, correspondant à la raideur du support mécanique de la grille 116, c'est-à-dire à la raideur de l'empilement formé de la couche piézoélectrique 125 et des électrodes 122, 128, et de la couche ou d'éléments isolants de soutien de l'empilement, une quatrième force de collage moléculaire ou force d'adhésion $F_{\text{adhésion}}$, résultante en particulier des forces de Van Der Waals s'exerçant entre la face inférieure de la grille 116 située en regard de la couche de diélectrique 111 de grille et la surface de la couche de diélectrique 111 de grille. Dans la première position, l'état de polarisation des électrodes des moyens d'actionnement, est adapté de sorte que :

$$\left|F_{électrostatique}\right| + \left|F_{adhésion}\right| < \left|F_{rappel}\right| + \left|F_{piézoélectrique}\right|$$

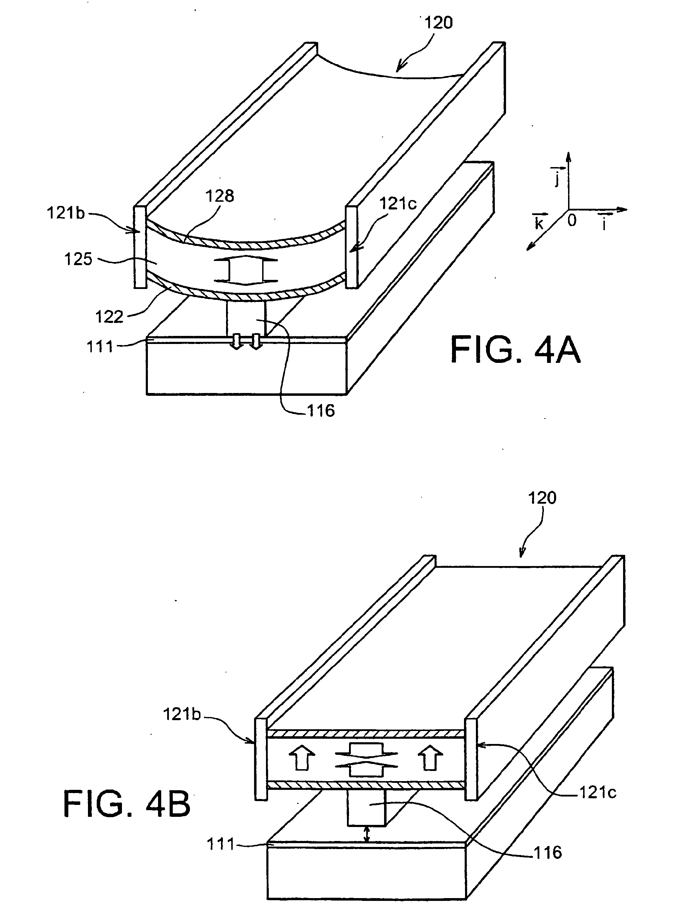

Une polarisation différente des moyens d'actionnement piézoélectriques peut permettre de déplacer cette dernière. La quatrième force peut lors devenir significative lorsque $\Delta$ est rendue faible, par exemple inférieure à 1 nm. Un collage (figure 4A) de la grille 116 sur la couche diélectrique 111 peut être réalisé lorsque la condition suivante est mise en oeuvre :

$$\left|F_{piézoélectrique}\right| + \left|F_{électrostatique}\right| + \left|F_{adhésion}\right| > \left|F_{rappel}\right|$$

Un dimensionnement prédéterminé des élements du dispositif, et une polarisation adaptée peuvent permettre de réaliser cette condition.

Dans la position de collage, la grille 116 est en contact avec la surface du diélectrique 111 de grille. Lorsque le dispositif est polarisé, la grille 116 du transistor est soumise, en première approximation, aux quatre forces présentées plus haut pour le mécanisme de collage.

Un décollement (figure 4B) de la grille 116 est mis en oeuvre quand la condition suivante est vérifiée :

$$\left|F_{piézoélectrique}\right| + \left|F_{rappel}\right| > \left|F_{électrostatique}\right| + \left|F_{adhésion}\right|$$

Un dimensionnement prédéterminé des éléments du dispositif et une polarisation adaptée peuvent permettre de réaliser cette condition.

On peut souhaiter conserver l'état de fonctionnement du transistor, et ce même après arrêt de toutes les polarisations ou des alimentations, afin de conférer au dispositif un fonctionnement non-volatile.

Pour cela, la grille 116 peut être maintenue, après arrêt des polarisations, dans une position dans laquelle elle se trouvait avant cet arrêt. Lorsque l'on éteint les polarisations, la grille 116 n'est soumise qu'aux forces de rappel de la structure et d'adhésion à la surface du diélectrique 111 de grille. Les forces piézoélectriques et électrostatiques dépendantes des différences de potentiel appliquées, deviennent nulles.

Deux cas de maintien de la position de la grille 116 peuvent par exemple être réalisés.

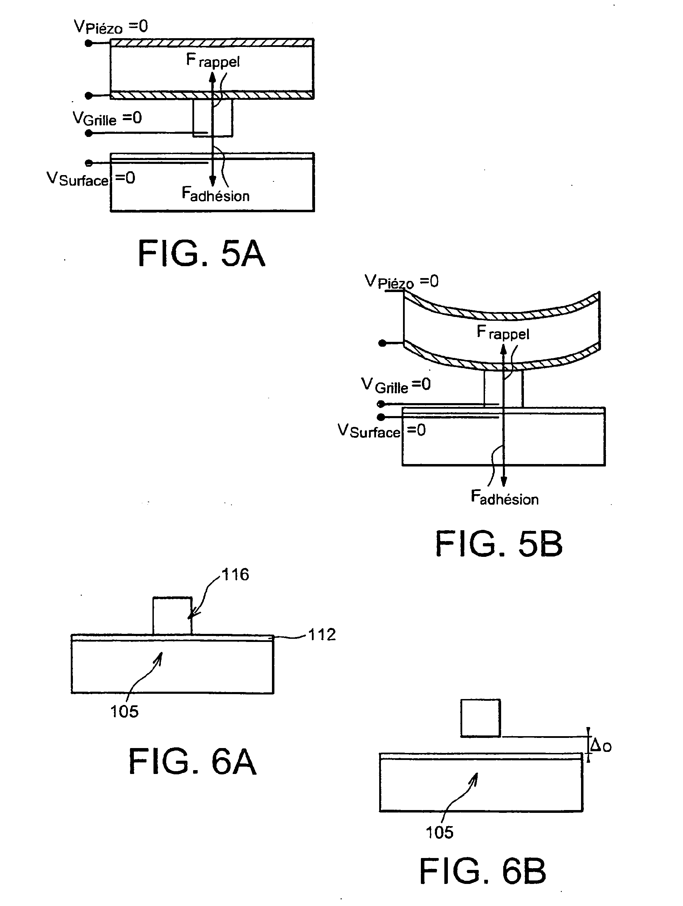

Un premier cas dans lequel, la grille est initialement, décollée ou à distance du diélectrique 111 de grille, et se trouve par exemple dans la première position avant extinction de l'alimentation ou des polarisations. Dans ce cas, après extinction, les forces d'adhésion sont faibles en comparaison des forces de rappel, ce qui permet de maintenir la grille 116 dans la position de repos (figure 5A). Il peut y avoir un déplacement faible de la grille entre la première position, lorsque l'empilement est polarisé mais maintenu à distance de du diélectrique de grille et la position « de repos » pour laquelle les polarisations sont éteintes. Par déplacement faible, on entend un déplacement faible par rapport à la distance $\Delta 0$ de repos.

Un deuxième cas dans lequel, la grille 116 est initialement collée contre, ou en contact avec, le diélectrique 111 de grille 116 avant extinction de l'alimentation ou des polarisations. Dans ce cas, après extinction, les forces d'adhésion ne sont pas négligeables devant les forces de rappel (figure 5B). Pour maintenir la grille collée sans polarisation, la condition suivante est mise en oeuvre :

$$\left|F_{adhésion}\right| > \left|F_{rappel}\right|$$

Un dimensionnement prédéterminé des éléments du dispositif, notamment une raideur de l'empilement et de la couche piézoélectrique adaptées ainsi qu'une distance $\Delta 0$ de repos choisie peuvent permettre de réaliser cette condition. Les moyens d'actionnement piézoélectriques ainsi que les éléments de soutien de l'empilement ont des dimensions et une composition adaptées, pour réaliser une raideur au bord de l'empilement qui permette de remplir la condition de maintien de la grille dans ledit deuxième cas qui vient d'être donné. Ainsi, lorsque les moyens d'actionnement piézoélectriques ne sont pas polarisés ou alimentés, la grille 116 est susceptible de rester dans sa position collée contre le diélectrique 111, à l'aide de forces d'adhésion qui varient fortement avec la distance séparant la grille 116 du diélectrique 111 de grille, d'avantage que les forces de rappel. Les forces de rappel peuvent être proportionnelles à cette distance tandis que les forces d'adhésion sont inversement proportionnelles à une puissance de cette distance, par exemple inversement proportionnelles au cube de cette distance pour des forces de Van der Waals.

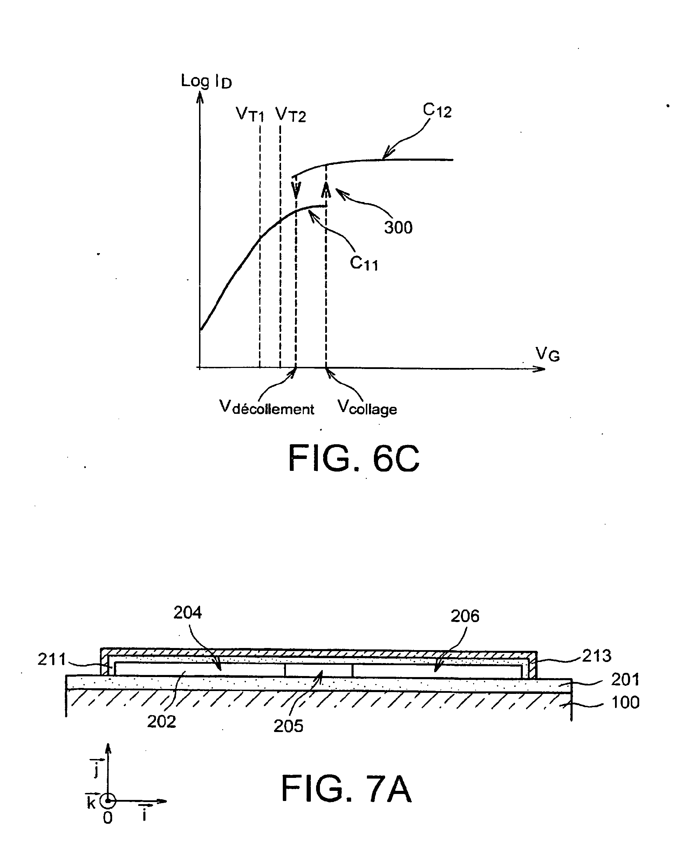

Un exemple de fonctionnement électrique du dispositif microélectronique va à présent être donné en liaison avec les figures 6A-6B et la figure 6C.

La tension de seuil $V_T$ du transistor peut être modulée en faisant varier l'épaisseur isolante entre la grille 116 et le canal 105 du transistor.

Sur la figure 6A, la grille 116 du transistor est collée contre ou est en contact avec le diélectrique 111 de grille. L'épaisseur isolante entre la grille 116 et le canal 105 correspond ainsi à l'épaisseur $e_1$ de la couche de diélectrique de grille. Dans cette position, le transistor a une première tension de seuil $V_{T1}$.

Sur la figure 6B, la grille 116 du transistor est située à une distance $\Delta$ du diélectrique 111 de grille 116. L'épaisseur isolante entre la grille 116 et le canal 105 correspond à l'épaisseur de la couche de diélectrique de grille ajoutée à une épaisseur $\Delta$ d'air entre la grille 116 et le diélectrique 111 de grille. Dans cette position, le transistor a une deuxième tension de seuil $V_{T2}$.

Le transistor peut avoir au moins deux valeurs de tension de seuil distinctes :

- une tension de seuil $V_{T1}$ faible lorsque la grille est en contact avec la surface du diélectrique de grille (grille collée),
- une tension de seuil $V_{T2}$ élevée lorsque la grille n'est pas en contact avec la surface de l'oxyde de grille (grille décollée).

Le transistor du dispositif a une tension de seuil qui peut être modifiée de manière dynamique, et avoir par exemple une première tension de seuil $V_{T1}$ qui peut être par exemple faible lorsque le transistor est à l'état passant et une deuxième tension de seuil $V_{T2}$ par exemple telle que $V_{T2} > V_{T1}$ et qui peut être élevée lorsque le transistor est à l'état bloqué. Les performances électriques du transistor sont ainsi améliorées par rapport à un transistor MOS classique de mêmes dimensions, dans la mesure où par rapport à un tel transistor, le transistor suivant l'invention a un courant $I_{ON}$ plus important circulant dans le canal à l'état passant, et un courant $I_{OFF}$ de canal à l'état bloqué, réduit.

Une courbe caractéristique représentative du courant de drain en fonction du potentiel appliqué sur la grille est donnée sur la figure 6C.

Une première portion de la courbe $C_{12}$ correspond à une position dans laquelle la grille est collée contre le diélectrique de grille 111, tandis qu'une autre portion de la courbe $C_{11}$ correspond à une position dans laquelle la grille est décollée ou en position de repos.

Un tel dispositif est susceptible de fonctionner à tension de seuil variable et ainsi de pouvoir avoir une pente sous un seuil inférieure à la limite de 60mV/dec des architectures classiques de transistor MOS à simple ou double grilles.

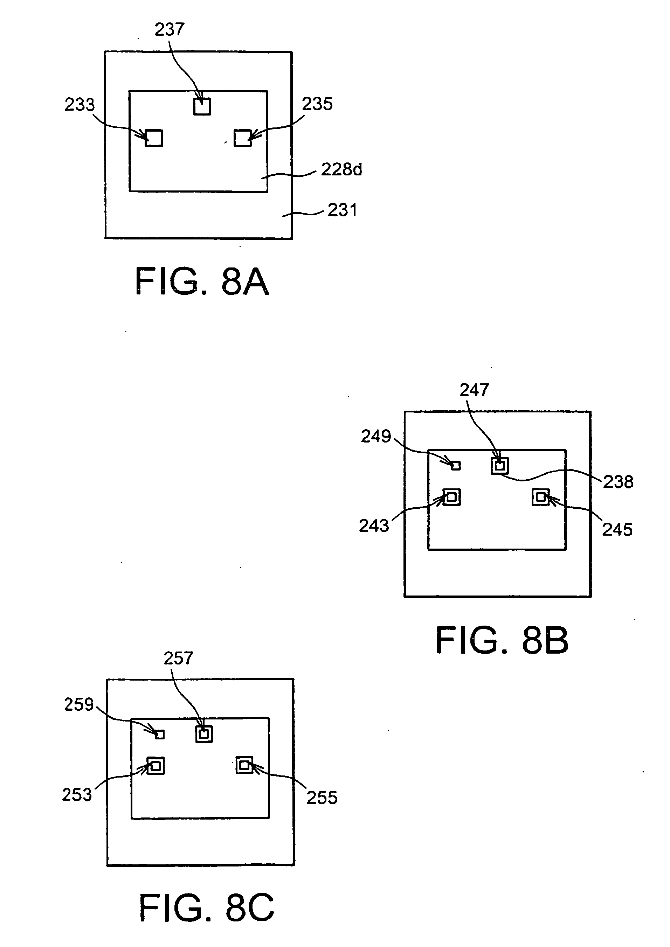

Un exemple de procédé de réalisation d'un dispositif microélectronique tel que décrit précédemment, doté d'un transistor comportant une grille suspendue et surmonté de moyens d'actionnement piézoélectriques, va à présent être donné en liaison avec les figures 7A-7J et 8A-8E (le dispositif en cours de réalisation étant représenté selon une vue en coupe transversale sur les figures 7A-7J et selon une vue de dessus sur les figures 8A-8E), les étapes de ce procédé ne faisant pas partie de l'invention mais illustrant des caractéristiques de dispositif faisant partie de l'invention..

Dans cet exemple, le matériau de départ est un substrat de type semi-conducteur sur isolant, tel qu'un substrat SOI (SOI pour « Silicon On Insulator » ou Silicium sur isolant). Le procédé n'est pas limité à un tel substrat et peut être adapté par exemple à une réalisation sur un substrat massif ou sur un substrat contraint. Le substrat de départ peut être formé d'une couche 200 de matériau semi-conducteur, par exemple du silicium monocristallin, surmontée d'une couche 201 de matériau isolant, par exemple d'oxyde de silicium, sur laquelle repose une fine couche de matériau semi-conducteur, par exemple du silicium monocristallin, et prévue pour former une couche active.

Dans la fine couche de matériau semi-conducteur, on défini, par exemple par gravure, au moins une zone semi-conductrice 202.

On pourra réaliser ensuite dans cette zone semi-conductrice 202, des zones actives de source 204, et de drain 206, de part et d'autre d'une zone de canal 205.

Puis, on recouvre la zone semi-conductrice 202, d'une couche destinée à former une zone de diélectrique 211 de grille surmontée d'une première couche sacrificielle 213. La première couche sacrificielle 213 est destinée à être supprimée ultérieurement afin de désolidariser la future grille du transistor de la couche de diélectrique 211 de grille, et réaliser un espace vide entre cette future grille et la zone de diélectrique 211 de grille.

La zone de diélectrique 211 de grille peut être par exemple à base d'oxyde de silicium et réalisée par une oxydation thermique d'une couche de silicium ou par dépôt d'un matériau diélectrique ayant une constante diélectrique élevée (« high-k » selon la terminologie anglo-saxonne) tel que du $HfO_2$ ou du $Al_2O_3$ ou du $HfSiO_x$. La zone de diélectrique 211 peut avoir une épaisseur comprise par exemple entre 1 nanomètre et 10 nanomètres, par exemple de l'ordre de 2 nanomètres.

**EP 2 015 358 B1**

La couche sacrificielle 213 est à base d'un matériau apte à être gravé de manière sélective par rapport aux autres matériaux de la structure. La couche sacrificielle 213 est à base d'un matériau apte à être gravé sélectivement par rapport, notamment, au diélectrique 211 et par rapport à la future grille. Le choix du matériau de la couche sacrificielle 213 peut être prévu également en fonction de celui des matériaux de la couche piézoélectrique et d'éléments de soutien de cette couche destinés à être réalisés ultérieurement, de manière à pouvoir être gravé sélectivement par rapport à cette couche piézoélectrique et ces éléments de soutien.

La première couche sacrificielle 213 peut être par exemple à base de Ge ou à base SiGe. Selon un autre exemple, la première couche sacrificielle 213 peut être à base de SiO$_2$ dans le cas où le diélectrique de grille est à base d'un matériau « high-k ». La couche sacrificielle 213 peut avoir une épaisseur comprise par exemple entre plusieurs nanomètres et plusieurs dizaines de nanomètres, par exemple de l'ordre de 4 nanomètres (figure 7A).

On réalise ensuite, à l'aide d'étapes de dépôt, de lithographie et de gravure, une grille 216 à base d'au moins un matériau de grille, métallique par exemple tel que du TiN, ou semi-conducteur par exemple tel que du silicium polycristallin, ou d'un empilement formé d'au moins une couche métallique et d'au moins une couche semi-conductrice. La grille 216 peut avoir une épaisseur comprise par exemple entre 10 nanomètres et 1 micromètre, par exemple de l'ordre de 50 nanomètres. La grille 216 peut avoir une dimension critique dc comprise par exemple entre plusieurs nanomètres et plusieurs centaines de nanomètres, par exemple de l'ordre de 40 nanomètres. (définie sur la figure 7A dans une direction parallèle au plan [0;$\vec{i}$;$\vec{k}$] d'un repère orthogonal [0;$\vec{i}$;$\vec{j}$;$\vec{k}$]).

On peut ensuite réaliser des zones d'extension, par exemple par implantation ionique.

Puis on forme des espaceurs isolants 217a, 217b de part et d'autre de la grille 216, à base d'un matériau isolant, par exemple tel que du SiO$_2$ ou du Si$_3$N$_4$ ou d'un empilement de ces deux matériaux.

On peut effectuer ensuite un dopage de la zone semi-conductrice 202, par exemple par implantation, de manière à réaliser les zones de source 204 et de drain 206.

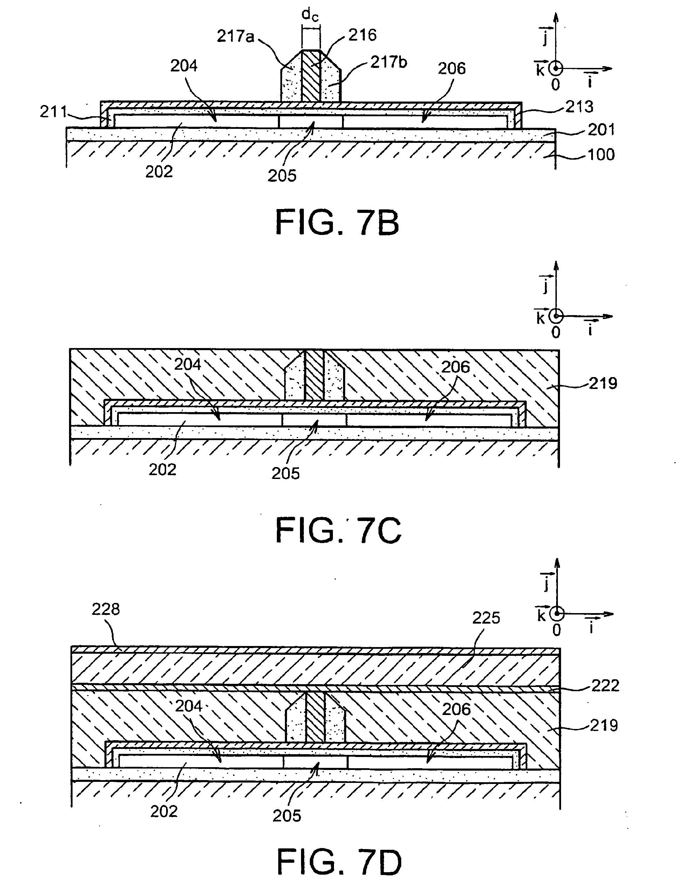

On a ainsi formé une structure semblable à celle d'un transistor MOS en technologie SOI, mais comportant une couche sacrificielle 213 entre la zone de diélectrique 211 de grille et la grille 216 (figure 7B).

La structure est ensuite recouverte d'une deuxième couche sacrificielle 219. Cette deuxième couche sacrificielle 219 peut être réalisée par dépôt, puis retirée dans une zone située au-dessus de la grille 216. Le retrait de la deuxième couche sacrificielle 219 du dessus de la grille peut être effectué par planarisation CMP (CMP pour Chemical Mechanical Planarisation) jusqu'à dévoiler la face supérieure de la grille 216. La deuxième couche sacrificielle 219 peut être à base d'un matériau apte à être gravé de manière sélective par rapport aux autres matériaux de la structure. La deuxième couche sacrificielle 219 peut être à base d'un matériau apte à être gravé sélectivement par rapport, notamment, au diélectrique 211 de grille et par rapport à la future grille. Le choix du matériau de la deuxième couche sacrificielle 219 peut être prévu également en fonction de celui des matériaux d'une couche piézoélectrique et d'éléments de soutien de cette couche piézoélectrique destinés à être réalisées ultérieurement, de manière à pouvoir être gravé sélectivement par rapport à cette couche piézoélectrique et ces éléments de soutien. La deuxième couche sacrificielle 219 peut être par exemple à base de Si. Selon une possibilité, la couche sacrificielle peut être à base d'un même matériau que la première couche sacrificielle, par exemple à base de SiGe ou de Ge. La deuxième couche sacrificielle 219 peut être éventuellement à base de SiO$_2$ notamment dans le cas où le diélectrique de grille est à base d'un matériau « high-k ».

La deuxième couche sacrificielle 219 peut être à base du même matériau que la première couche sacrificielle 213 (figure 7C).

On dépose ensuite un empilement de couches à partir duquel des moyens d'actionnement piézoélectriques sont destinés à être définis.

Cet empilement peut être formé d'une couche 225 à base d'un matériau piézoélectrique comme par exemple de l'AlN, du PZT, du LiNbO$_3$ ou du LiTaO$_3$, du PMN-PT, du LiNbO$_3$, du LiTaO$_3$ intercalée entre deux couches conductrices 222, 228 destinées à jouer le rôle d'électrodes de polarisation de la couche piézoélectrique 225.

Les couches conductrices 222, 228 peuvent être formées d'un matériau métallique, choisi en fonction du matériau employé pour la couche piézoélectrique 225, et qui peut être par exemple du Mo, du Ti ou du Pt. La couche piézoélectrique 225 peut, quant à elle, être réalisée par dépôt d'un matériau piézoélectrique ou par report de ce matériau sur la couche conductrice 222, en utilisant un mécanisme de collage. Un report permet avantageusement de former une couche de matériau piézoélectrique monocristallin.

Le choix du matériau des couches conductrices 222, 228 et du matériau de la couche piézoélectrique 225 est prévu de manière à rendre optimales les propriétés de piézoélectricité, et en particulier la faculté de la couche 225 à se déformer sous l'action d'une tension électrique imposée par les électrodes, de préférence faible ou la plus faible posssible.

Dans un cas par exemple où le matériau piézoélectrique de la couche 225 est de l'AlN, les couches conductrices 222 et 228 peuvent être à base de Mo.

La couche de matériau piézoélectrique peut avoir une épaisseur comprise par exemple entre 100 nanomètres et 1 micromètre, par exemple de l'ordre de 150 nanomètres. Les couches conductrices 222, 228 peuvent quant à elles avoir une épaisseur comprise entre 10 nanomètres et 100 nanomètres, par exemple de l'ordre de 10 nanomètres.

On réalise ensuite au moins un motif, par exemple par photolithographie et gravure de l'empilement de couches

8

222, 225, 228, et de la deuxième couche sacrificielle 219, de manière à définir un bloc dans lequel, une électrode inférieure 222a, un bloc de matériau piézoélectrique 225a sur l'électrode inférieure, et une électrode supérieure 228a sur le bloc 225a de matériau piézoélectrique sont réalisés. Le bloc formé peut avoir un motif rectangulaire de largeur W et de longueur L (la longueur L étant définie sur la figure 7D dans une direction parallèle au vecteur $\vec{i}$ du repère orthogonal $[0;\vec{i};\vec{j};\vec{k}]$).

Puis, on forme au moins une couche isolante 231 sur la structure par exemple à base de $SiO_2$ ou de $Si_3N_4$, ou un empilement de couches isolantes, par exemple formé d'une fine couche à base de $Si_3N_4$, recouverte par une couche à base de $SiO_2$.

On retire ensuite une portion de cette couche isolante 231 ou de cet empilement, par exemple par gravure, dans une zone située au-dessus de l'électrode 228a supérieure.

Les portions restantes de la couche isolante 231 entourent le transistor ainsi que l'empilement comprenant le bloc 225a piézoélectrique et les électrodes 222a, 228a. Les portions restantes de la couche isolante 231 forment ainsi un soutien ou un élément d'armature, apte à soutenir l'empilement de couches 222a, 225a, 228a de l'actionneur piézoélectrique. Le matériau de la couche isolante 231 peut être choisi de manière à avoir une rigidité supérieure à celle du matériau piézoélectrique 225, de manière à favoriser le déplacement de la grille induit par la déformation de la couche piézoélectrique.

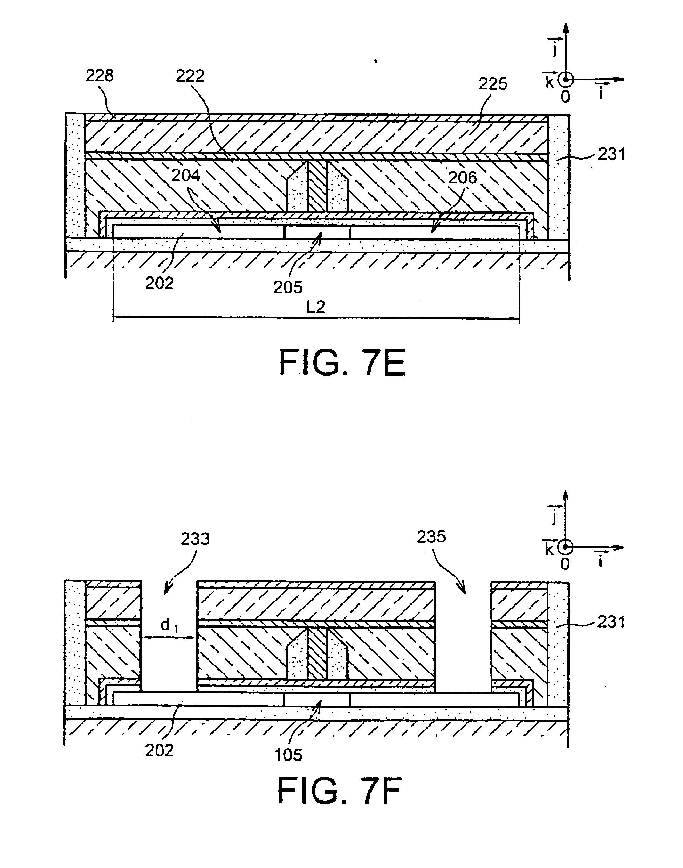

On définit ensuite (figures 7E et 8A), de part et d'autre de la grille du transistor, par exemple par photolithographie et à travers l'empilement de couches 228a, 225a, 222a, des couches sacrificielles 219, 213, et de la zone de diélectrique 211 de grille, des ouvertures 233, 235, dévoilant respectivement la zone de source 204 et la zone de drain 206 définies dans la zone semi-conductrice 202. On réalise également au moins une ouverture 237, à travers les couches 228a, 225a, 222a, de manière à dévoiler la grille 216 ou la première couche conductrice 222.

Les ouvertures 233, 235, 237, peuvent être prévues avec un diamètre ou une dimension critique d1 (défini (e) sur la figure 7F dans une direction parallèle au plan $[0;\vec{i};\vec{k}]$).

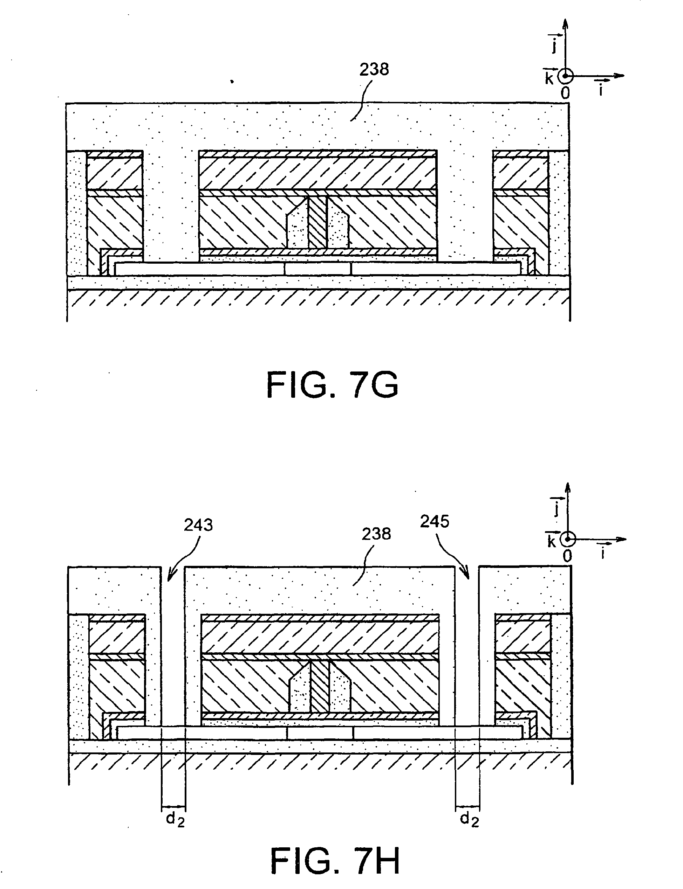

Puis, on effectue un remplissage des ouvertures 233, 235 et 237 à l'aide d'un matériau isolant 238, par exemple du $SiO_2$ (figures 7G). Ensuite, on peut effectuer un polissage mécano-chimique (CMP) de la couche de matériau isolant 238.

Dans les ouvertures 233, 235, et 237 remplies de matériau isolant 238, on réalise respectivement des trous 243, 245 et 247, de diamètre ou de dimension critique d2 (défini(e) sur la figure 7H dans une direction parallèle au plan $[0;\vec{i};\vec{k}]$) inférieur à celui d1 des ouvertures 233, 235 et 237. Les trous 243, 245 et 247 dévoilent respectivement la zone de source 204, la zone de drain 206, et la grille 216 ou la première couche conductrice 222 (figure 7G).

Un trou 249, dévoilant l'électrode supérieure 228a, est également réalisé.

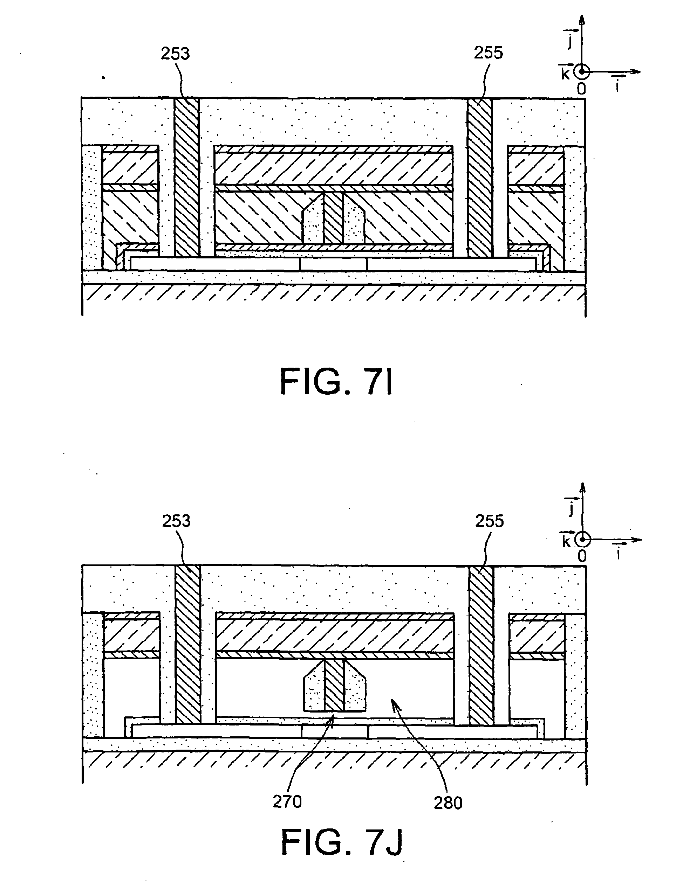

On remplit ensuite les trous 243, 245 et 247, 249 à l'aide d'au moins un matériau conducteur, par exemple un métal tel que du tungstène, de manière à former des plots conducteurs 253, 255 et 257, 259 dans les trous 243, 245 et 247, 249. Les plots conducteurs 253, 255, 257, 259, sont en contact respectivement avec la zone de source 204, la zone de drain 206, avec la grille 216 ou avec l'électrode inférieure 222a, et avec l'électrode supérieure 228a (figures 7I et 8C).

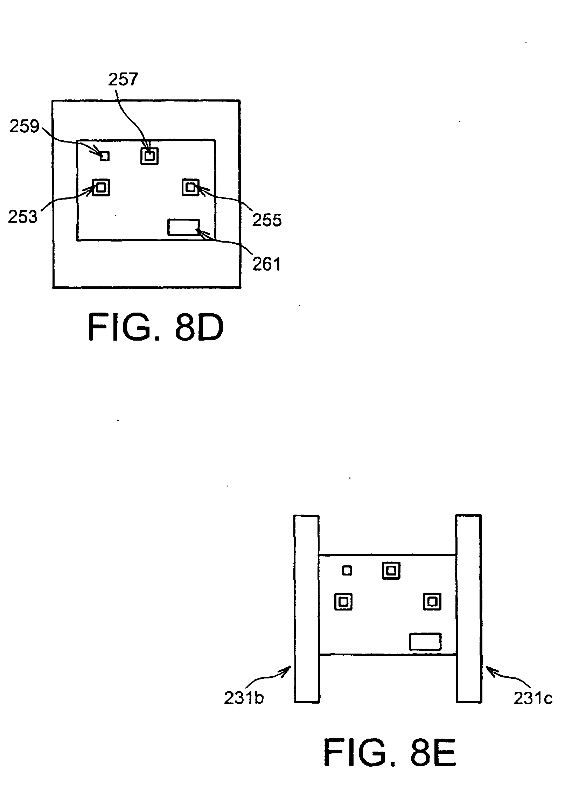

On réalise ensuite au moins une ouverture 261 dans le bloc, traversant l'empilement 220 et les couches sacrificielles 213, 219. L'ouverture 261 peut être réalisée, par exemple à l'aide d'étapes de photolithographie et de gravure (figure 8D).

Ensuite, on effectue un retrait partiel ou total (figure 7J) des couches sacrificielles 213, 219, de manière à désolidariser la grille 216 du diélectrique de grille 211. Le retrait des couches sacrificielles 213, 219, peut être réalisé par exemple par gravure plasma délocalisé, le plasma étant formé dans une chambre donnée puis délocalisé dans une autre chambre dans laquelle est placé le dispositif comportant les couches sacrificielles à retirer.

Le retrait de la première couche sacrificielle 213 est effectué de manière à réaliser un espace 270 entre la grille 216 et la couche diélectrique 211 de grille. Le retrait peut être réalisé par gravure sélective de la première couche vis-à-vis de la grille, du diélectrique de grille. Le retrait peut être par exemple réalisé par gravure sélective d'une première couche sacrificielle semi-conductrice, par exemple en Si, vis-à-vis d'une grille en Ti, d'un diélectrique de grille à base de $SiO_2$. La gravure peut être également sélective vis-à-vis des espaceurs ou/et des éléments de soutien par exemple lorsqu'ils sont à base de $Si_3N_4$.

La deuxième couche sacrificielle 219 peut être également retirée de manière à former un espace autour, ou tout autour de la grille 216. Le retrait peut être réalisé par gravure sélective de la deuxième couche vis-à-vis de la grille, du diélectrique de grille et des éléments de soutien.

Le retrait peut être par exemple réalisé par gravure sélective d'une première couche sacrificielle en SiGe, vis-à-vis d'une grille en Ti, d'un diélectrique de grille à base de $SiO_2$ et d'espaceurs ou/et d'éléments de soutien à base de $Si_3N_4$.

Dans le cas où les deux couches sacrificielles 213 et 219 sont à base d'un même matériau, le retrait des deux couches sacrificielles 213 et 219 peut être réalisé en même temps. Un retrait, éventuellement total, de la deuxième couche sacrificielle 219 peut quant à lui être effectué de manière à réaliser une cavité 280 autour de la grille 216. Après cette étape, de retrait des couches sacrificielles 213, 219, la grille 216 est maintenue ou rattachée par sa face supérieure, à l'électrode inférieure 222a de l'actionneur (figure 7J).

Dans l'exemple de réalisation qui vient d'être donné, l'électrode supérieure 228a reposant sur la couche piézoélectrique 225 n'est connectée ou reliée électriquement à aucun des plots 253, 255, 257, de contact de source, de contact de drain, et de contact de grille 257.

Si besoin, l'électrode supérieure 228a peut être connectée ou reliée électriquement ultérieurement au plot 253 de source, ou au plot 255 de drain, lors d'étapes ultérieures d'une partie de procédé communément appelées « étapes de back-end » au cours desquelles, on réalise une pluralité de niveaux métalliques d'interconnexions des composants du circuit intégré.

Selon une possibilité, la couche de soutien 231, peut être à nouveau gravée de manière à libérer des côtés de l'empilement formé des électrodes 222a, 228a et du bloc piézoélectrique 225a. Dans le cas où un motif de rectangle a été formé dans l'empilement de couches 222a, 225a, 228a, la gravure peut être réalisée de manière à libérer deux côtés, par exemple les deux plus longs côtés du rectangle afin de permettre à la couche piézoélectrique 225a de se déformer plus aisément, sous l'action d'une polarisation.

Sur la figure 8E, l'empilement formé des électrodes 222a, 228a et du bloc piézoélectrique 225a est maintenu en suspension au-dessus du substrat 200 par l'intermédiaire de deux éléments isolants ou blocs de soutien 231b, 231c, isolant formés par gravure de la couche isolante 231.

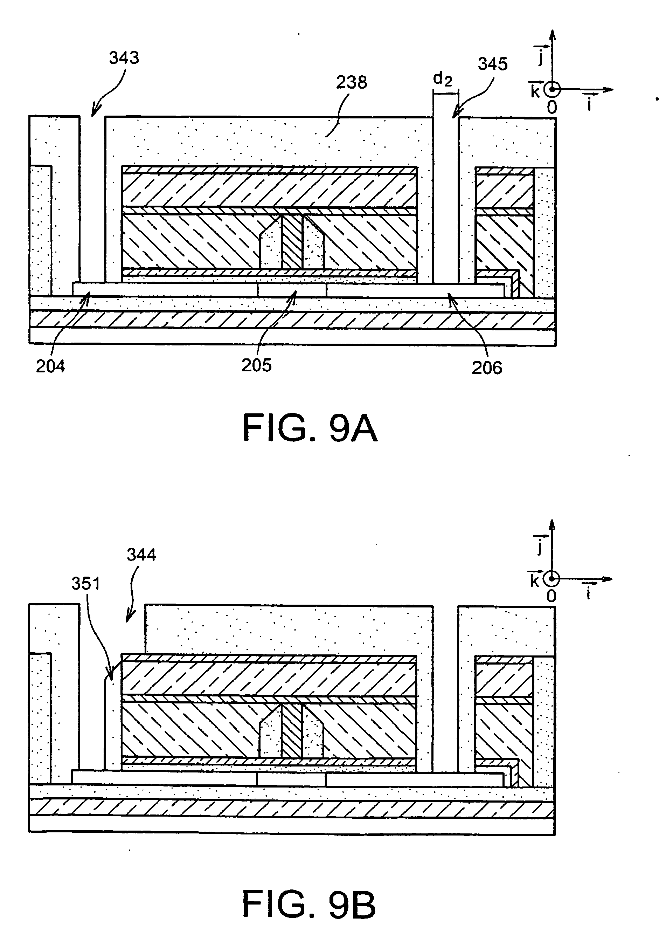

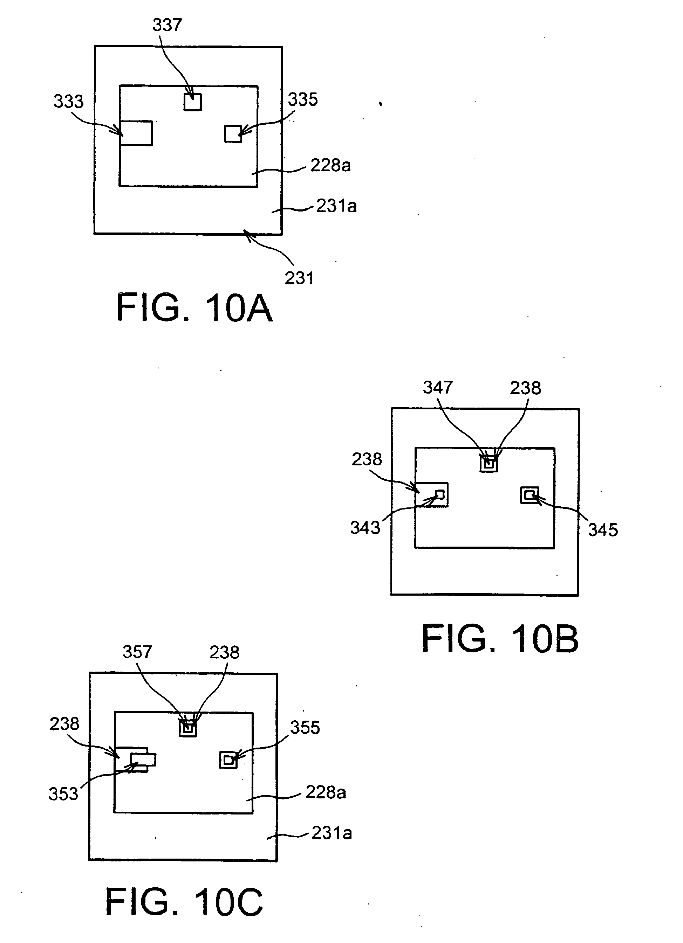

Une variante de l'exemple de procédé qui vient d'être décrit, et en particulier de la réalisation des plots de contact, va à présent être donnée en liaison avec les figures 9A-9D, et 10A-10C (le dispositif en cours de réalisation étant représenté selon une vue en coupe transversale sur les figures 9A-9D et selon une vue de dessus sur les figures 10A-10C)

les étapes de ce procédé ne faisant pas partie de l'invention mais illustrant des caractéristiques de dispositif faisant partie de l'invention.

Pour cette variante, on réalise les mêmes étapes que dans l'exemple de procédé précédemment décrit jusqu'à la réalisation de la couche de soutien 231 à base de matériau isolant (jusqu'à la figure 7E incluse).

On définit ensuite, de part et d'autre du transistor, par exemple par des étapes de photolithographies et de gravures à travers l'empilement de couches 228a, 225a, 222a, des couches sacrificielles 219, 213, et de la zone de diélectrique 211 de grille, des ouvertures 333, 335, dévoilant respectivement la zone de source 204, la zone de drain 206 définies dans la zone semi-conductrice 202, et la grille 216. On forme également au moins une ouverture 337, dévoilant la zone grille 216 ou la première couche conductrice 222a. L'ouverture 333 dévoilant la zone de source 204 peut être prévue avec un diamètre ou une dimension critique supérieure à celui des autres ouvertures 335, 337 (figure 10A).

On effectue ensuite un remplissage des ouvertures 333, 335 et 337 à l'aide d'un matériau isolant 238, par exemple du $SiO_2$.

Dans les ouvertures 333, 335, et 337 remplies de matériau isolant 238, on réalise respectivement des trous 343, 345 et 347, de diamètre inférieur à celui, ou de dimension critique d2 inférieure à celle d1 des ouvertures 333, 335 et 337 (figures 9A et 10B).

On élargi ensuite l'embouchure 344 d'un trou formé en regard d'une zone active, par exemple l'embouchure 344 du trou 343 dévoilant la zone de source 204. L'embouchure du trou 343 est élargie de manière à dévoiler une partie de la face supérieure de l'électrode supérieure 228a de l'actionneur piézoélectrique. On effectue cet élargissement de manière à conserver une zone isolante 351 ou un espaceur isolant 351 entre le trou 343 et l'électrode inférieure 222a de l'actionneur.

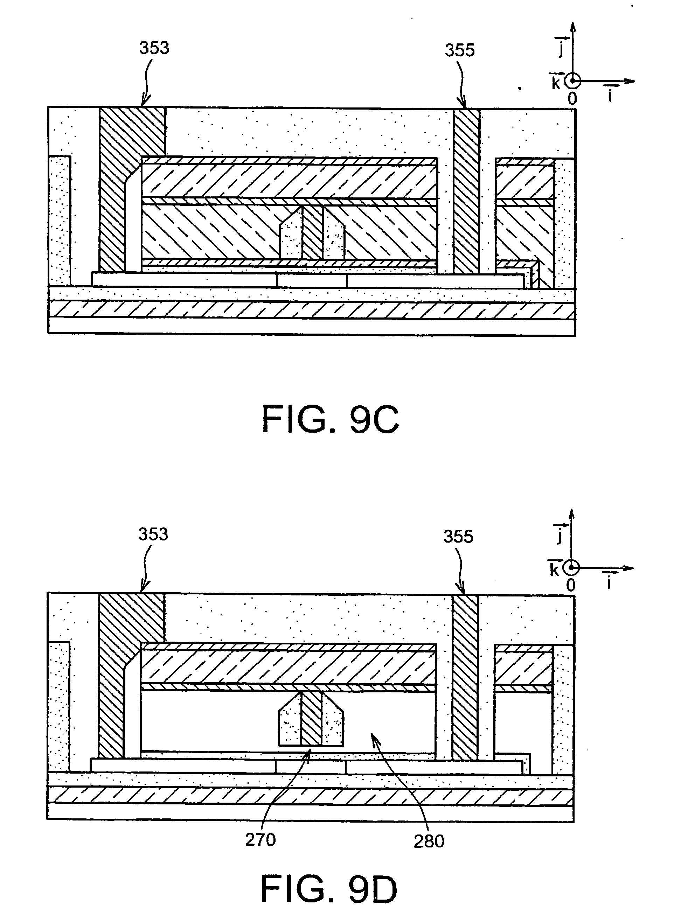

On remplit ensuite les trous 343, 345 et 347, à l'aide d'au moins un matériau conducteur, par exemple un métal tel que du tungstène, de manière à former des plots métalliques 353, 355 et 357 dans les trous 343, 345 et 347. Les plots métalliques 355 et 357, sont en contact respectivement avec la zone de drain, et avec la grille 216. Le plot 353 formé du trou 343 à embouchure élargie et rempli de métal, est quant à lui en contact avec l'électrode supérieure 228a et la zone de source 204 (figures 9C et 10C).

On réalise ensuite au moins une ouverture dévoilant les couches sacrificielles 213, 219. L'ouverture peut être réalisée de manière à traverser les couches sacrificielles 213, 219, ou selon une variante, être réalisée en périphérie de la structure, mais de manière à dévoiler les couches sacrificielles 213, 219.

Ensuite, on effectue, à travers l'ouverture une gravure des couches sacrificielles 213, 219, de manière à retirer ces couches sacrificielles 213, 219, et notamment désolidariser la grille 216 du diélectrique de grille 211. Un espace 270 entre la grille 216 et la couche diélectrique 211 de grille est ainsi formé. Une cavité 280 tout autour de la grille 216 peut être également formée suite au retrait de la deuxième couche sacrificielle 219, par exemple par gravure isotrope sélective (figure 9D).

Selon la variante qui vient d'être donnée, un plot en contact avec la zone de source 204 et la deuxième couche conductrice 222 de l'électrode supérieure 222a a été réalisé. Il est possible, en effectuant un procédé semblable, de former un plot en contact avec la zone de drain 206 et la deuxième couche conductrice 222 de l'électrode supérieure 222a.

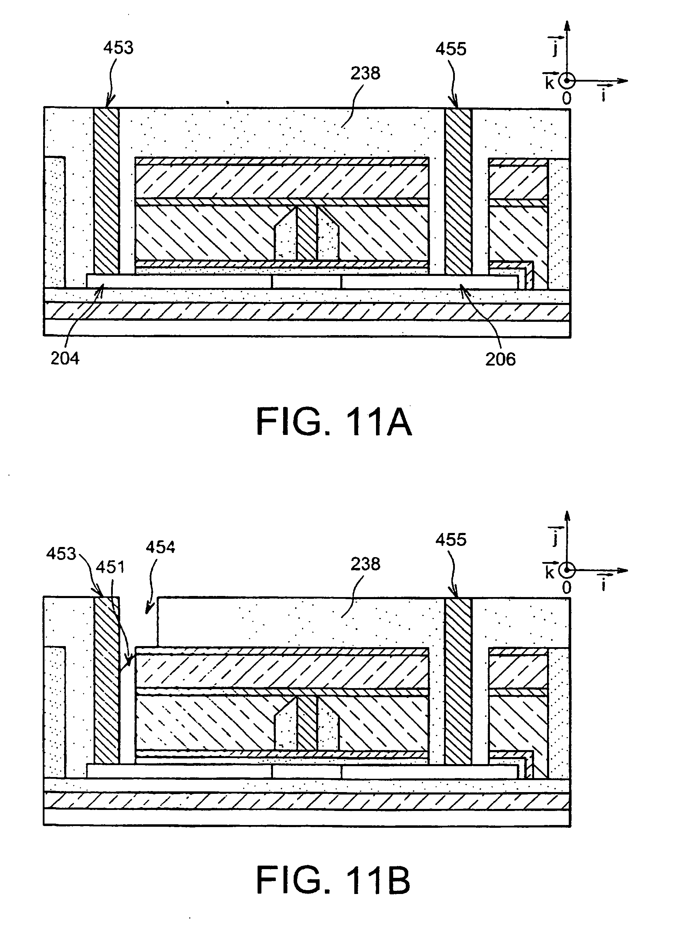

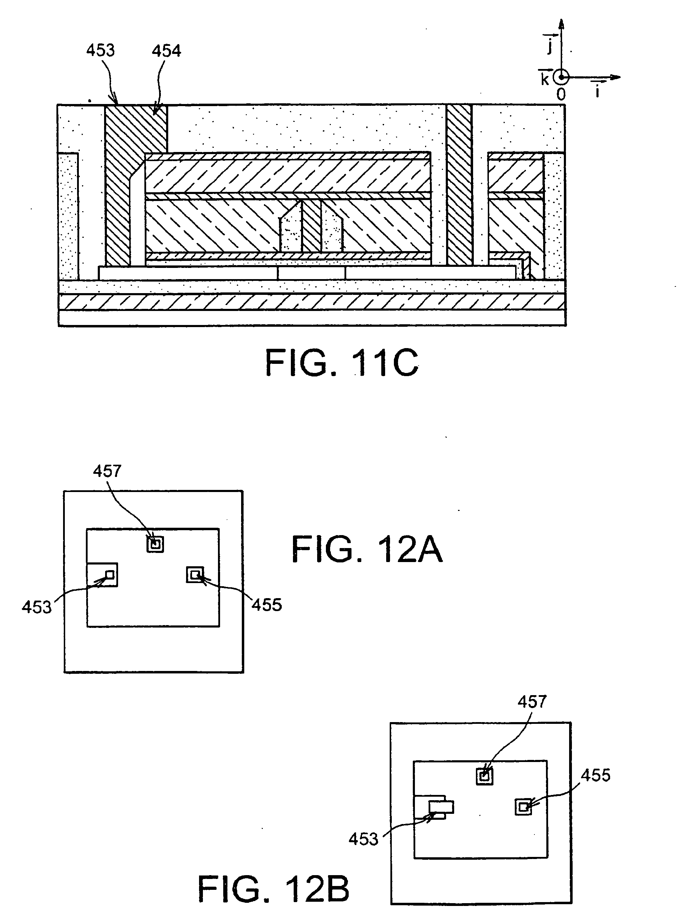

Une autre variante de réalisation des plots de contacts, va à présent être donnée en liaison avec les figures 11A-11C, et 12A-12B (le dispositif en cours de réalisation étant représenté selon une vue en coupe transversale sur les figures 11A-11C et selon une vue de dessus sur les figures 12A-12B), les étapes de ce procédé ne faisant pas partie de l'invention mais illustrant des caractéristiques de dispositif faisant partie de l'invention..

Pour cette variante, on réalise les mêmes étapes que dans l'exemple de procédé précédemment décrit jusqu'à la réalisation des trous 343, 345 et 347, de diamètre inférieur d2 à celui d1 des ouvertures 333, 335 et 337.

On remplit ensuite les trous 343, 345 et 347, à l'aide d'un métal, par exemple du tungstène, de manière à former des plots conducteurs 453, 455 et 457 dans les trous 343, 345 et 347. Les plots conducteurs 453, 455 et 457, sont en contact respectivement avec la zone de source 204, la zone de drain 206, et avec la grille 216 ou la première électrode 222 (figures 11A et 12A).

A proximité du plot 453 en contact avec la zone de source 204, on réalise ensuite un trou 444 supplémentaire dans le matériau isolant 239, de manière à dévoiler une portion de l'électrode supérieure 228a et des flancs du plot 453. Le trou 444 supplémentaire est réalisé de manière à ce qu'une zone isolante 459 est conservée entre le plot 453 et l'électrode inférieure 222a (figure 11B).

Puis, on effectue un remplissage du trou 444, à l'aide d'un métal, par exemple tel que du tungstène, de manière à former une zone métallique 454 de prolongement du plot 453, en contact avec l'électrode supérieure 228a de l'actionneur piézoélectrique (figures 11C et 12B).

Ensuite, on effectue les étapes telles que décrites précédemment, de réalisation d'au moins une ouverture dans la structure, pour accéder aux couches sacrificielles 213, 219.

Ensuite, on effectue, à travers ladite ouverture une gravure des couches sacrificielles 213, 219, de manière à réaliser un retrait de ces couches sacrificielles 213, 219, et désolidariser la grille 216 du diélectrique de grille 211.

La deuxième couche sacrificielle 219 peut être également retirée de manière à former un espace autour, ou tout autour de la grille 216. Dans le cas où les deux couches sacrificielles 213 et 219 sont à base d'un même matériau, le retrait des deux couches sacrificielles 213 et 219 peut être réalisé en même temps.

Après cette étape, de retrait des couches sacrificielles, la grille 216 est maintenue ou rattachée par sa face supérieure, à l'électrode inférieure 222a de l'actionneur.

Selon la variante qui vient d'être donnée, un plot en contact avec la zone de source 204 et la deuxième couche conductrice 222 de l'électrode supérieure 222a a été réalisé. Il est possible, en effectuant un procédé semblable, de former un plot en contact avec la zone de drain 206 et la deuxième couche conductrice 222 de l'électrode supérieure 222a.

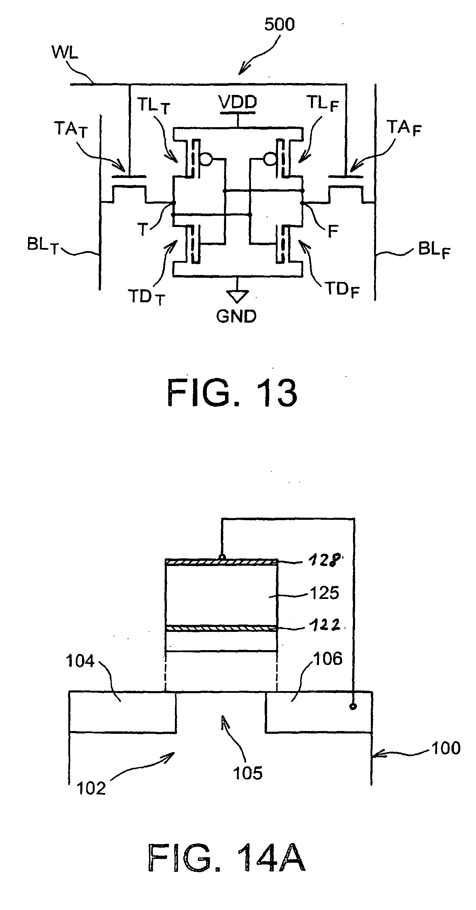

Un premier exemple de cellule mémoire 500 à accès aléatoire suivant l'invention, est illustré sur la figure 13.

Cette cellule mémoire 500 est une cellule de mémoire statique SRAM de type 6T, c'est à dire dotée de 6 transistors. La cellule 500 comprend une première pluralité de transistors formant un premier inverseur et un deuxième inverseur, connectés selon une configuration de bascule ou communément appelée « flip-flop ». Les premiers transistors de charge $TL_T$ et de conduction $TD_T$ forment le premier inverseur de la bascule, tandis que les deuxièmes transistors de charge $TL_F$ et de conduction $TD_F$ forment le deuxième inverseur de la bascule.

La première pluralité de transistors peut être formée d'un premier transistor de charge $TL_T$, ainsi que d'un deuxième transistor de charge $TL_F$. Les transistors de charge $TL_T$ et $TL_F$, peuvent être, par exemple de type P. La cellule 500 peut être également dotée d'un premier transistor de conduction $TD_T$ et d'un deuxième transistor de conduction $TD_F$, par exemple de type N.

Les transistors $TL_T$, $TL_F$, $TD_T$, $TD_F$ de la cellule formant la bascule sont semblables à celui précédemment décrit en liaison avec les figures 2A-2B, doté d'une grille suspendue mobile et de moyens d'actionnement piézo-électriques pour déplacer la grille.

La cellule comprend également des transistors d'accès $TA_T$ et $TA_F$, par exemple de type NMOS.

Les connexions dans la cellule peuvent être semblables à celles d'une cellule mémoire 6T conventionnelle.

Dans cet exemple, la grille du deuxième transistor de charge $TL_F$ est connectée à celle du deuxième transistor de conduction $TD_F$, et à un premier noeud de stockage T de la cellule 500. La grille du premier transistor de charge $TL_T$ est connectée à celle du premier transistor de conduction $TD_T$, et à un deuxième noeud de stockage F.

Les sources des transistors de charge $TL_T$, $TL_F$, peuvent quant à elles, être reliées entre elles et à une tension d'alimentation VDD, tandis que le drain du premier transistor de charge $TL_T$ est relié au premier noeud T, le drain du deuxième transistor de charge $TL_F$ étant quant à lui relié au deuxième noeud F.

Les transistors de charge $TL_T$ et $TL_F$, connectés à la tension d'alimentation VDD, ont dans cet exemple pour fonction de maintenir un niveau logique '1', par exemple égal à une tension VDD, à l'un ou l'autre des noeuds de stockage T ou F, par exemple au premier noeud T, en fonction de la valeur logique mémorisée dans la cellule 500. Les transistors de conduction $TD_T$ et $TD_F$, connectés à la masse de la cellule GND, ont pour rôle de maintenir un niveau logique '0', égal à GND, à l'un ou l'autre des noeuds stockage en fonction de la valeur logique mémorisée.

Les deux transistors d'accès $TA_T$ et $TA_F$ sont prévus, en fonction de la manière dont ils sont polarisés, pour autoriser l'accès aux potentiels des noeuds de stockage lors d'un cycle de lecture ou d'écriture, et pour bloquer l'accès à la cellule 300, lorsque la cellule 300 est dans un mode de rétention d'information.

Le premier transistor d'accès TA$_T$ et le deuxième transistor d'accès TA$_F$ comportent chacun une grille reliée à une ligne de mot WL. La source du premier transistor d'accès TA$_T$ est reliée à une première ligne de bit BL$_T$, tandis que la source du deuxième transistor d'accès TA$_F$ est reliée à une deuxième ligne de bit BL$_F$. Le drain du premier transistor d'accès TA$_T$ est quant à lui relié au premier noeud de stockage T, tandis que le drain du deuxième transistor d'accès TA$_F$ est relié au deuxième noeud de stockage F.

L'actionnement de la grille suspendue des transistors TD$_T$, TD$_F$, TL$_T$ et TL$_F$ à l'aide de moyen piézoélectriques, permet de moduler leur tension de seuil V$_T$. Comme cela a été décrit précédemment, les moyens d'actionnement piézoélectriques permettent de conférer à la cellule 500 un fonctionnement non-volatile, dans la mesure où la grille mobile actionnée par de tels moyens est apte à rester en position, même après extinction de la tension d'alimentation VDD. Ainsi, après extinction de l'alimentation de la cellule 500, cette dernière peut être réinitialisée ou remise lors de son re-démarrage dans l'état dans lequel elle se trouvait avant extinction.

En ce qui concerne les connexions entre l'actionneur piézoélectrique respectif et les électrodes respectives, des transistors TD$_T$, TD$_F$, TL$_T$ et TL$_F$, deux configurations peuvent être mises en oeuvre.

Selon une première configuration (figure 14A), l'électrode supérieure 128 des moyens d'actionnement piézoélectriques et la source 104 du transistor sont connectées ensemble.

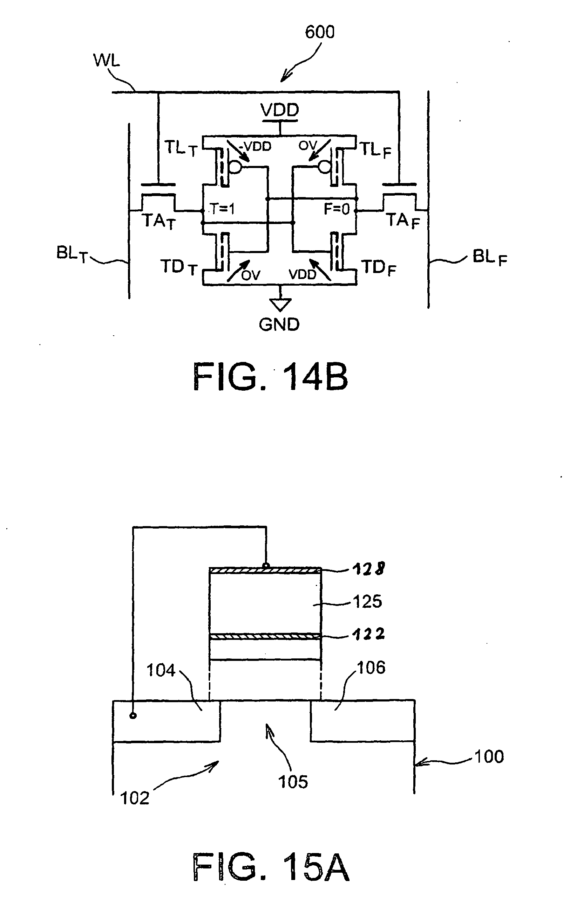

Sur la figure 14B, les transistors TD$_T$, TD$_F$, TL$_T$ et TL$_F$, d'une cellule 600 semblable à la cellule 500 ont cette première configuration.

Selon une deuxième configuration (figure 15A), l'électrode supérieure 128 des moyens d'actionnement piézoélectriques et le drain 106 du transistor sont connectés ensemble.

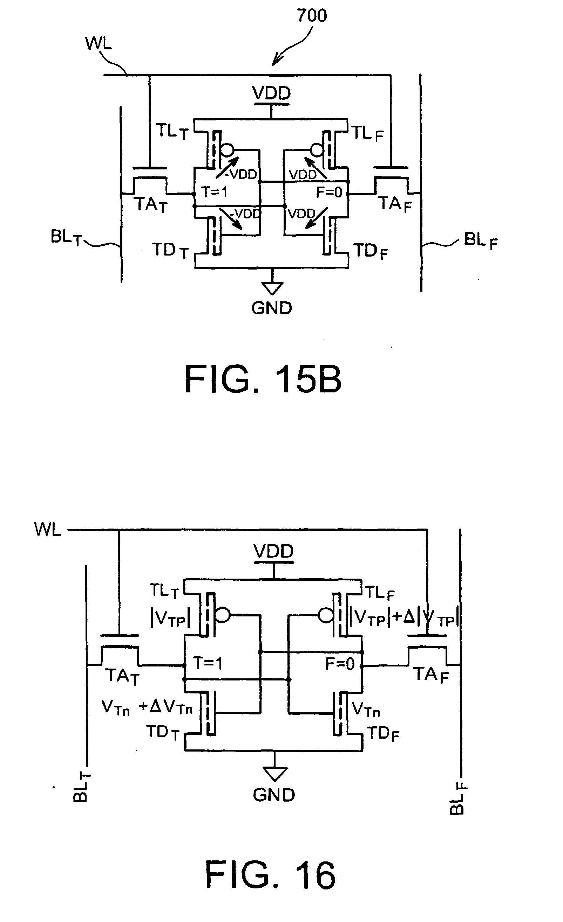

Sur la figure 15B, une cellule 700 semblable à la cellule 500, comporte des transistors TD$_T$, TD$_F$, TL$_T$ et TL$_F$, adoptant la deuxième configuration.

Dans la deuxième configuration, on peut avantageusement obtenir une modulation ou une variation de la tension de seuil des transistors plus importante.

Pour la cellule 600 dotée de transistors TD$_T$, TD$_F$, TL$_T$ et TL$_F$, se trouvant dans la première configuration, la différence de potentiels entre grille et la source pour le premier transistor de conduction TD$_T$ peut être de 0V tandis que la différence de potentiels entre grille et la source du deuxième transistor de conduction TD$_F$ est +VDD, ce qui donne une différence de potentiel totale de 1xVDD.

Comme montré sur la figure 15B, dans la cellule 700 dotée de transistors adoptant la deuxième configuration, la différence de potentiels entre grille et drain pour le premier transistor de conduction TD$_T$ peut être de -VDD tandis que la différence de potentiels entre grille et le drain du deuxième transistor de conduction TD$_F$ est +VDD, ce qui permet d'obtenir une différence de potentiel totale entre les deux transistors de conduction de 2xVDD, plus importante que dans la première configuration. Il en est de même pour les transistors de charge TL$_T$ et TL$_F$.

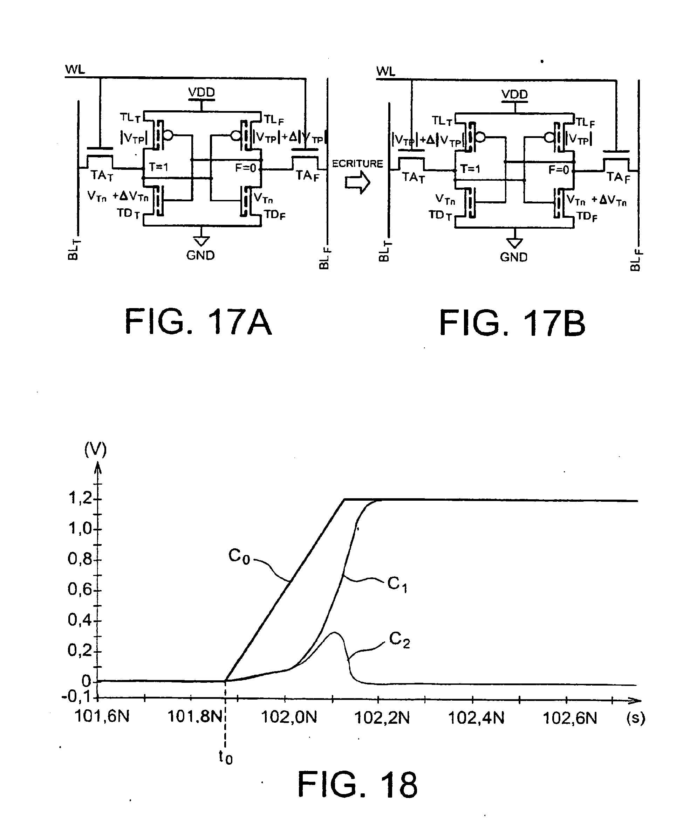

Un exemple de fonctionnement de la cellule 700 va être donné en liaison avec les figures 16 et 17.

Les transistors TD$_T$, TD$_F$, TL$_T$, TL$_F$, sont connectés selon la deuxième configuration avec leurs actionneurs piézoélectriques respectifs. La tension de seuil respective des transistors est susceptible d'être modulée en fonction du mode, rétention ou lecture ou écriture, dans lequel se trouve la cellule 700.

En mode de rétention, la ligne de mot WL peut être maintenue au potentiel de masse GND. Les transistors d'accès TA$_T$ et TA$_F$ sont dans un état bloqué et l'information stockée dans la cellule 700 est isolée des lignes de bit BL$_T$ et BL$_F$.

La cellule 700 est configurée de sorte que dans le mode de rétention, la tension de seuil du premier transistor de conduction TD$_T$ est augmentée de $+\Delta VT_N$ par rapport à une valeur de tension de seuil VT$_N$, tandis que la tension de seuil du deuxième transistor de charge TL$_F$ est augmentée de $+\Delta|VT_P|$ par rapport à une valeur de tension de seuil $|VT_P|$, VT$_N$ et VT$_P$ correspondant à la tension de seuil des transistors PMOS et NMOS lorsque la grille est collée sur la couche diélectrique de grille, les tensions de seuil étant alors minimales. La cellule 700 est également configurée de sorte que dans le mode de rétention, la tension de seuil du deuxième transistor de conduction TO$_F$ est égale à une valeur de tension de seuil VT$_N$, tandis que la tension de seuil du premier transistor de charge TL$_T$ est égale à une valeur de tension de seuil $|VT_P|$.

Cette configuration des tensions de seuil des transistors TD$_T$, TD$_F$, TL$_T$, TL$_F$ lorsque la cellule 700 se trouve en mode de rétention, est illustré sur la figure 16. Une telle configuration permet d'obtenir une stabilité en rétention RNM accrue de la cellule 700 et d'autre part des courants de fuites réduits. L'augmentation de la tension de seuil du premier transistor de conduction TD$_T$ et du deuxième transistor de charge TL$_F$ permet respectivement de diminuer leur courant sous le seuil et de limiter la décharge du noeud de stockage T et la charge du noeud de stockage F, dans un cas par exemple où l'on souhaite conserver un niveau logique '1' dans le premier noeud T et un niveau logique '0' dans le deuxième noeud.

La faible tension de seuil du premier transistor de charge TL$_T$ et du deuxième transistor de conduction TD$_F$ permettent d'augmenter leur courant de conduction, ce qui renforce la charge du noeud T et la décharge du noeud F.

Préalablement à un accès de la cellule 700 en lecture, les lignes de bit BL$_T$ et BL$_F$ peuvent être chargées à un potentiel égal VDD. Ensuite en mode de lecture, la ligne de mot WL est polarisée au potentiel VDD, afin de permettre un accès aux noeuds de stockage T et F de la cellule 700. La stabilité de la cellule 700 en mode lecture dépend notamment de la valeur du potentiel du noeud de stockage F qui se trouve au niveau logique '0', par exemple le deuxième noeud F. Cette tension doit de préférence rester inférieure à la tension de commutation de l'inverseur connecté au noeud de stockage de niveau logique '1', par exemple le premier noeud T. Cette condition est liée au diviseur de tension entre la deuxième ligne de bit $BL_F$ et la masse GND de la cellule 700, formé par le deuxième transistor d'accès $TA_F$ et le deuxième transistor de conduction $TD_F$ connectés au noeud de niveau logique '0'.

Pour améliorer la marge au bruit en lecture de la cellule 700, cette cellule est mise en oeuvre de sorte que le courant linéaire qui traverse le deuxième transistor de conduction $TD_F$ est supérieur au courant de saturation du deuxième transistor d'accès $TA_F$.

Le rapport de gain en courant, entre les transistors de conduction et d'accès, est typiquement de l'ordre de 2. Pour des transistors prévus avec une grille de dimension critique inférieure à 65 nm, ce rapport tend vers 3. Les transistors de conduction $TD_T$ et $TD_F$, et de charge $TL_T$ et $TL_F$, à grille mobile et actionnement piézoélectrique de la grille permettent de conférer à la cellule mémoire 700 un rapport de gain en courant supérieur à celui d'une cellule SRAM 6T suivant l'art antérieur et de même dimension. La déformation mécanique du matériau piézoélectrique des transistors de conduction $TD_T$ et $TD_F$ et de charge $TL_T$ et $TL_F$, permet de moduler leur tension de seuil favorablement, de manière renforcer la stabilité de la cellule en lecture (SNM).

Comme pour le mode rétention précédemment décrit, en mode de lecture, la tension de seuil du premier transistor de conduction $TD_T$ et du deuxième transistor de charge $TL_F$ est augmentée, ce qui permet respectivement, de limiter la décharge du noeud T et de diminuer la charge du noeud F. La tension de seuil du premier transistor de charge $TL_T$ et celle du deuxième transistor de conduction $TD_F$ sont également faibles, ce qui permet d'augmenter leur courant de conduction et de renforcer la charge du premier noeud de stockage T et la décharge du deuxième noeud de stockage F, dans un cas par exemple où le premier noeud T est destiné à être à un niveau logique '1' tandis que le noeud F est à un niveau logique '0'. En ce qui concerne le rapport de gain en courant, entre les transistors de conduction et d'accès, ce dernier augmente par rapport au cas conventionnel, où l'information stockée n'impacte la tension de seuil des transistors grâce à l'augmentation du courant de conduction du deuxième transistor de conduction du transistor $TD_F$ liée à la diminution de sa tension.

Préalablement à une écriture, une des deux lignes de bit, par exemple la deuxième ligne de bit $BL_F$ peut être à un potentiel VDD, tandis que la ligne de bit complémentaire $BL_F$ peut être polarisée au potentiel de masse GND. Ensuite, la ligne de mot WL est polarisée à un potentiel VDD afin d'écrire dans la cellule 700.

Le basculement de l'information logique contenu dans la cellule mémoire 700 s'accompagne d'une variation des tensions de seuil des transistors de conduction $TD_T$ et $TD_F$ et de charge $TL_T$ et $TL_F$, comme cela est illustré sur les figures 17A-17B.

La cellule 700 est configurée de sorte que lorsqu'elle passe dans un mode d'écriture, la tension de seuil du deuxième transistor de conduction $TD_F$ est susceptible d'augmenter, et passer de $VT_N$ à $(VT_N + \Delta VT_N)$, tandis que la tension de seuil du premier transistor de charge $TL_T$ est susceptible d'augmenter, de $+\Delta|VT_P|$ par rapport à une valeur de tension de seuil $|VT_P|$. Dans ce cas les transistors $TD_F$ et $TL_T$ passent d'un état de grille collée à un état de grille décollée

La cellule 700 est également configurée de sorte que dans le mode de rétention, la tension de seuil du premier transistor de conduction $TD_T$ est susceptible diminuer, et passer de $(VT_N + \Delta VT_N)$ à $(VT_N)$, tandis que la tension de seuil du deuxième transistor de charge $TL_F$ est diminuée de $+\Delta|VT_P|$ par rapport à une valeur de tension de seuil $(|VT_P|+\Delta|VT_P|)$ Dans ce cas, les transistors $TD_T$ et $TL_F$ passent d'un état de grille décollée à un état de grille collée.

Cette modulation de la tension de seuil est relative au changement de polarisation des actionneurs piézoélectriques associés à chacun des transistors $TL_T$, $TL_F$, $TD_T$, $TD_F$. Ces changements de polarisation vont entraîner une déformation complémentaire des matériaux piézoélectriques, modulant la différence de potentiels entre la grille et la surface du canal des transistors.

Un mode d' « arrêt », c'est-à-dire lorsque la tension d'alimentation de la cellule 700 est coupée, n'empêche pas de conserver l'information stockée dans les noeuds T et F. Même si ces noeuds perdent leur potentiel après arrêt des alimentations, l'information sera conservée grâce au fonctionnement non-volatile des transistors $TL_T$, $TL_F$, $TD_T$ et $TD_F$ tel que décrit précédemment en liaison avec les figures 3, 4, 5, 6.

En mode de « démarrage », la cellule mémoire 700 est mise sous tension d'alimentation. Les noeuds de stockage de la cellule T et F basculent en tension suivant le dernier état mémorisé, qui est conservé grâce à une différence adaptée entre les forces de rappel s'exerçant sur les couches de matériaux piézoélectriques et les forces de collage à l'interface grille/diélectrique de grille des transistors $TL_T$, $TL_F$, $TD_T$ et $TD_F$.

La figure 18 illustre une phase de démarrage de la cellule mémoire 700. Sur cette figure la courbe C0 représente l'évolution du potentiel d'alimentation, tandis que les courbes C1 et C2 représentent respectivement, l'évolution du potentiel au premier noeud T et l'évolution du potentiel au deuxième noeud F. Avant un instant t0, la cellule 700 n'est pas alimentée. Puis à l'instant t0, la cellule 700 est à nouveau alimentée (courbe C0 arrivant progressivement à la valeur VDD).

Le potentiel du premier noeud T retrouve une valeur par exemple égale VDD correspondant à un état logique « 1 » (courbe C1 croissante atteignant la valeur VDD) tandis que le potentiel du deuxième noeud F retrouve une valeur par exemple égale à GND ou 0 volts correspondant à un état logique '0' (courbe C2).

L'information qui était présente dans les noeuds T et F avant l'arrêt de l'alimentation de la cellule 700, est conservée dans la mesure où les noeuds T et F retrouvent, sans qu'une opération d'écriture soit nécessaire, le potentiel qu'ils avaient préalablement à l'extinction.

Un tableau ci-dessous, donne un exemple de comparaison des caractéristiques électriques de la cellule 700 décrite précédemment et d'une cellule 6T SRAM standard.

| Cellules | Cellule 6T standard | Cellule 700 |
|---|---|---|
| $I_{OFF}$ (pA) | 44 | 19.4 |
| $I_{PG}$ (pA) | 7.6 | 7.6 6 |
| $I_{CELL}$ ($\mu$A) | 42 | 43 |
| SNM (mV) | 187 | **237** |

Les résultats ont été obtenus avec des grilles de dimension critique de l'ordre de 65nm, les cellules 700 et 6T standard présentant le même dimensionnement.

Une modulation de la tension de seuil des transistors de conduction $TD_T$, $TD_F$, et de charge $TL_T$ et $TL_F$ telle que mise en oeuvre dans la cellule 700, permet d'améliorer la marge au bruit statique SNM de l'ordre de 50mV, soit de plus de 25%, et de réduire les courants de fuite d'un facteur supérieur à 2,2, par rapport à la cellule 6T standard. Le courant $I_{CELL}$ de la cellule 700 est également amélioré par rapport à la cellule de l'art antérieur.

**DOCUMENTS CITES :**

[NAT'05] : S. Natarajan, et al., «Emerging memory technologies - mainstream or hearsay ? », VLSI Design Automation and Test, 2005.

[TAK'01] : K. Takeuchi, et al., « A Study of Threshold Voltage Variation for Ultra SmallBulk and SOI CMOS », IEEE TED, VOL.48, No.9, September 2004.

[YAM'04] : M. YAMAOKA, et al., « Low Power SRAM Menu for SOC Application Using Yin-Yang-Feedback memory Cell Technology », Symposium on VLSI circuits, Digest of Technical Papers, Honolulu, USA, June 2004.

**Revendications**

**1.** Cellule de mémoire vive non-volatile à accès aléatoire, comprenant :

au moins une première pluralité de transistors ($TL_T$, $TL_F$, $TD_T$, $TD_F$) formant une bascule, les transistors de la première pluralité de transistors ($TL_T$, $TL_F$, $TD_T$, $TD_F$) comportant respectivement : un diélectrique de grille et une grille (116, 216) mobile, suspendue au-dessus du diélectrique de grille, la grille étant située à une distance ajustable de ladite zone de diélectrique de grille, les transistors de la première pluralité de transistors étant en outre surmontés respectivement de moyens d'actionnement piézoélectriques aptes à déplacer la grille par rapport à ladite zone de canal (105) les moyens d'actionnement piézoélectriques comprenant un empilement (120, 220) formé d'au moins une couche de matériau piézoélectrique (125, 225) reposant sur une première électrode (122, 222) de polarisation, une deuxième électrode (128, 228) de polarisation reposant sur la couche de matériau piézoélectrique, les transistors de la première pluralité de transistors étant aptes respectivement à adopter : au moins une première position dans laquelle leur grille (116) est disjointe du diélectrique de grille et située à une première distance du canal, et à adopter au moins une deuxième position dans laquelle ladite grille est située à une deuxième distance du canal, différente de la première distance, la cellule de mémoire étant **caractérisée en ce que**, dans ladite deuxième position, ladite grille est maintenue en contact avec la zone de diélectrique de grille :

- à l'aide des moyens d'actionnement piézoélectriques, les moyens d'actionnement piézoélectriques étant polarisés, ou
- par collage électrostatique, les moyens d'actionnement piézoélectriques n'étant pas polarisés.

**2.** Cellule de mémoire vive non-volatile à accès aléatoire selon la revendication 1, la grille (116, 216) étant rattachée à ladite première électrode (122, 222).

**3.** Cellule de mémoire vive non-volatile à accès aléatoire selon la revendication 1 ou 2, dans lequel la grille est en contact avec ladite première électrode (122, 222).

**4.** Cellule de mémoire vive non-volatile à accès aléatoire selon l'une des revendications 1 à 3, les transistors de la première pluralité de transistors ayant une zone de source (104) connectée à la deuxième électrode (128) de leurs moyens d'actionnement piézoélectriques respectifs.

**5.** Cellule de mémoire vive non-volatile à accès aléatoire selon l'une des revendications 1 à 3, les transistors de la première pluralité de transistors ayant une zone de drain (106) connecté à la deuxième électrode (128) de leurs moyens d'actionnement piézoélectriques respectifs.

**6.** Cellule de mémoire vive non-volatile à accès aléatoire selon l'une des revendication 1 à 5, comprenant en outre des moyens d'alimentation aptes à alimenter les transistors de la première pluralité de transistors et leur moyens d'actionnements respectifs, les transistors de la première pluralité de transistors étant aptes respectivement à adopter une position donnée parmi lesdites première position et deuxième position, et apte en outre à maintenir la grille dans ladite position donnée après arrêt ou extinction desdits moyens d'alimentation.

**7.** Cellule de mémoire vive non-volatile à accès aléatoire selon l'une des revendications 1 à 6, dans lequel les transistors de la première pluralité de transistor ont une tension de seuil variable, susceptible de varier par déplacement de la grille (116, 216) mobile à l'aide des moyens d'actionnement piézoélectriques.

**8.** Cellule de mémoire vive non-volatile à accès aléatoire selon l'une des revendications 1 à 7, susceptible d'adopter plusieurs modes de fonctionnement dont au moins un mode de rétention d'information contenue dans la cellule, au moins un mode de lecture d'information contenue dans la cellule, et au moins un mode d'écriture dans la cellule, les transistors de la première pluralité de transistor ayant respectivement une tension de seuil variable.

**9.** Cellule de mémoire vive à accès aléatoire selon l'une des revendications 1 à 8, ladite première pluralité de transistors comprenant :

un premier transistor de charge ($TL_T$) et un deuxième transistor de charge ($TL_F$),
- un premier transistor de conduction ($TD_T$) et d'un deuxième transistor de conduction ($TD_F$).

**10.** Cellule de mémoire vive à accès aléatoire selon l'une des revendications 1 à 9, comprenant au moins un premier transistor d'accès ($TA_T$) et au moins un deuxième transistor d'accès ($TA_F$) disposés respectivement entre une première ligne de bit ($BL_T$) et un premier noeud de stockage (T), et entre une deuxième ligne de bit ($BL_F$) et un deuxième noeud de stockage (F),

**11.** Mémoire SRAM, comprenant une pluralité de cellules suivant l'une des revendications 1 à 10.

**12.** Dispositif microélectronique comprenant au moins une mémoire SRAM selon la revendication 11.

**Claims**

**1.** A non-volatile random-access memory cell, including:

- at least a first plurality of transistors ($TL_T$, $TL_F$, $TD_T$, $TD_F$) forming a switch, the transistors of the first plurality of transistors respectively including : a gate dielectric and a mobile gate (116, 216), suspended abode the gate dielectric, the gate being located at an adjustable distance from said gate dielectric zone, the transistors of the first plurality of transistors also being surmounted, respectively, by piezoelectric operating means adapted to move the gate in relation to said channel zone (105), the piezoelectric operating means including a stack (120, 220) formed of at least one layer of piezoelectric material (125, 225) resting on a first polarisation electrode (122, 222), a second polarisation electrode (128, 228) resting on the layer of piezoelectric material, wherein the transistors of the first plurality of transistors are adapted respectively to adopt: at least a first position wherein their gate (116) is disconnected from said gate dielectric and located at a first distance from the channel, and to adopt at least a second position wherein said gate is located at a second distance from the channel that is different from the first distance, the cell being **characterized in that**, in said second position, said gate is maintained in contact with the gate dielectric

- with piezoelectric operating means, said piezoelectric operating means being put into polarisation state,
- by electrostatic adhesion, said piezoelectric operating means being not polarized.

2. The non-volatile random-access memory cell according to claim 1, the gate (116, 216) being attached to said first electrode (122, 222).

3. The non-volatile random-access memory cell according to claim 1 or 2, the gate (116, 216) being in contact with said first electrode (122, 222).

4. The non-volatile random-access memory cell according to any of claims 1 to 3, where the transistors of the first plurality of transistors have a source zone (104) connected to the second electrode (128) of their respective piezoelectric operating means.

5. The non-volatile random-access memory cell according to any of claims 1 to 3, were the transistors of the first plurality of transistors have a drain zone (106) connected to the second electrode (128) of their respective piezoelectric operating means.

6. The non-volatile random-access memory cell according to any of claims 1 to 5, further including power supply means adapted to power the transistors of the first plurality of transistors and their respective operating means, the transistors of the first plurality of transistors being adapted respectively to adopt a given position among the said first position and second position, and also adapted to maintain the gate in the said given position after shut-down or removal of the said power supply means.

7. The non-volatile random-access memory cell according to any of claims 1 to 6, wherein the transistors of the first plurality of transistors have a variable threshold voltage which is able to vary by movement of the mobile gate (116, 216), effected by the piezoelectric operating means.

8. The non-volatile random-access memory cell according to any of claims 1 to 7, liable to adopt several operating modes, at least one of which is a mode for retention of the information contained in the cell, at least one mode to read the information container in the cell, and at least one mode to write to the cell, the transistors of the first plurality of transistor respectively having a variable threshold voltage.

9. A random-access active memory cell according to claim 8, the said first plurality of transistors including:

- a first charge transistor ($TL_T$) and a second change transistor ($TL_F$),
a first conduction transistor ($TD_T$) and a second conduction transistor ($TD_F$).

10. The random-access active memory cell according to any of claims 1 to 9, including at least a first access transistor and at least a second access transistor respectively placed between a first bit line and a first storage node, and between a second bit line and a second storage node,

11. An SRAM memory including a plurality of cells according to any of claims 1 to 10.

12. A microelectronic device including at least one SAM memory according to claim 11.

**Patentansprüche**

1. Nicht-flüchtige Speicherzelle mit wahlfreiem Zugriff (Random-Access-Speicher), welche umfasst:

- wenigstens eine erste Mehrzahl von eine Kippschaltung bildenden Transistoren (TLT, TLF, TDT, TDF), wobei die Transistoren der ersten Mehrzahl von Transistoren jeweils aufweisen: ein Gate-Dielektrikum und ein mobiles bzw. bewegliches Gate (116, 216), das über dem Gate-Dielektrikum hängend angeordnet ist, derart dass das Gate in einer einstellbaren Entfernung von der genannten Gate-Dielektrikumszone angeordnet ist, wobei des weiteren über den Transistoren der ersten Mehrzahl von Transistoren jeweils piezoelektrische Betätigungsmittel angebracht sind, die das Gate relativ gegenüber der genannten Kanalzone (105) verschieben können, und wobei die piezoelektrischen Betätigungsmittel einen Schichtstapel (120, 220) umfassen, der aus wenigstens einer Schicht (125, 225) aus piezoelektrischem Material gebildet wird, die auf einer ersten Vorspannelektrode (122, 222) aufruht, und aus einer auf der Schicht aus piezoelektrischem Material ruhenden zweiten Vorspann-Elektrode, und wobei ferner die Transistoren der ersten Mehrzahl von Transistoren jeweils wenigstens eine erste Stellung einnehmen können, in welcher ihr Gate (116) von dem Gate-Dielektrikum getrennt und in einem ersten Abstand von dem Kanal liegt, und wenigstens eine zweite Stellung einnehmen können, in welcher das genannte Gate in einem zweiten, von dem ersten Abstand verschiedenen Abstand von dem Kanal liegt, wobei die Speicherzelle **dadurch gekennzeichnet ist, dass** in der genannten zweiten Stellung das Gate in Berührung mit der Gate-Dielektrikums-Zone gehalten wird, und zwar

- mit Hilfe der piezoelektrischen Betätigungsmittel in deren vorgespanntem Zustand, oder
- mittels elektrostatischer Klebung, im nicht-vorgespannten Zustand der piezoelektrischen Betätigungsmittel.

2. Nicht-flüchtige Speicherzelle mit wahlfreiem Zugriff (Random-Access-Speicherzelle) nach Anspruch 1, bei welcher das Gate an der genannten ersten Elektrode (122, 222) befestigt ist.

3. Nicht-flüchtige Speicherzelle mit wahlfreiem Zugriff (Random-Access-Speicherzelle) nach Anspruch 1 oder 2, bei welcher das Gate mit der genannten ersten Elektrode (122, 222) in Kontakt steht.

4. Nicht-flüchtige Speicherzelle mit wahlfreiem Zugriff (Random-Access-Speicherzelle) nach einem der Ansprüche 1 bis 3, bei welcher die Transistoren der ersten Mehrzahl von Transistoren eine Source-Zone (104) aufweisen, die mit der zweiten Elektrode (128) ihrer betreffenden piezo-elektrischen Betätigungsmittel verbunden ist.

5. Nicht-flüchtige Speicherzelle mit wahlfreiem Zugriff (Random-Access-Speicherzelle) nach einem der Ansprüche 1 bis 3, bei welcher die Transistoren der ersten Mehrzahl von Transistoren eine Drain-Zone (106) aufweisen, die mit der zweiten Elektrode (128) ihrer betreffenden piezoelektrischen Betätigungmittel verbunden ist.

6. Nicht-flüchtige Speicherzelle mit wahlfreiem Zugriff (Random-Access-Speicherzelle) nach einem der Ansprüche 1 bis 5, welche des weiteren Mittel zur Stromversorgung der Transistoren der ersten Mehrzahl von Transistoren und ihrer betreffenden Betätigungsmittel umfasst, wobei die Transistoren der ersten Mehrzahl von Transistoren jeweils eine von den genannten ersten und zweiten Stellungen einnehmen können und des weiteren nach dem Anhalten bzw. der Abschaltung der genannten Stromversorgunnsmittel das Gate in der genannten jeweiligen Stellung halten können.

7. Nicht-flüchtige Speicherzelle mit wahlfreiem Zugriff (Random-Access-Speicherzelle) nach einem der Ansprüche 1 bis 6, in welcher die Transistoren der ersten Mehrzahl von Transistoren eine variable Schwellwertspannung besitzen, die durch Verschieben des beweglichen Gates (116, 216) mit Hilfe der piezoelektrischen Betätigungsmittel variiet werden kann.

8. Nicht-flüchtige Speicherzelle mit wahlfreiem Zugriff (Random-Access-Speicherzelle) nach einem der Ansprüche 1 bis7, welche mehrere Funktions-Betriebsarten einnehmen kann, darunter wenigstens eine Betriebsart der bewahrenden Erhaltung von Informationsgehalt der Zelle, wenigstens eine Betriebsart des Lesens von in der Zelle enthaltener Information, und wenigstens eine Betriebsart des Schreibens in die Zelle, wobei die Transistoren der ersten Mehrzahl von Transistoren jeweils eine variable Schwellwertspannung aufweisen.

9. Nicht-flüchtige Speicherzelle mit wahlfreiem Zugriff (Random-Access-Speicherzelle) nach einem der Ansprüche 1 bis 8, in welcher die genannte erste Mehrzahl von Transistoren umfasst:

- einen ersten Ladetransistor (TLT) und einen zweiten Ladetransistor (TLF),
- einen ersten Leitungstransistor (TDT) und einen zweiten Leitungstransistor (TDF).

10. Nicht-flüchtige Speicherzelle mit wahlfreiem Zugriff (Random-Access-Speicherzelle) nach einem der Ansprüche 1 bis 9, welche wenigstens einen ersten Zugangstransistor (TAT) und wenigstens einen zweiten Zugangstransistor (TAF) umfasst, die jeweils zwischen einer eresten Bit-Leitung (BLT) und einem ersten Speicherknoten (T) sowie zwischen einer zweiten Bitleitung (BF) und einem zweiten Speicherknoten angeordnet sind.

11. SRAMSpeicher, welcher eine Mehrzahl von Speicherzellen gemäß einem der Ansprüche 1 bis 10 aufweist.

12. Mikroelektronische Vorrichtung, welche wenigstens einen SRAMSpeicher gemäß Anspruch 11 aufweist.

17

VDD

10

12

13

15

T

VDD

F

16

11

# FIG. 1

128

125

122

106

104

100

102

105

# FIG. 2A

# FIG. 2B

**FIG. 3A**

**FIG. 3B**

FIG. 4A

FIG. 4B

$V_{Piézo} = 0$

$F_{rappel}$

$V_{Grille} = 0$

$V_{Surface} = 0$

$F_{adhésion}$

## FIG. 5A

$V_{Piézo} = 0$

$F_{rappel}$

$V_{Grille} = 0$

$V_{Surface} = 0$

$F_{adhésion}$

## FIG. 5B

116

112

105

## FIG. 6A

$\Delta_o$

105

## FIG. 6B

Log $I_D$

$V_{T1}$  $V_{T2}$

$C_{12}$

$C_{11}$

300

$V_G$

$V_{décollement}$   $V_{collage}$

## FIG. 6C

204

206

211

213

201

100

202

205

$\vec{j}$

$\vec{k}$

$\vec{i}$

0

## FIG. 7A

FIG. 7B

FIG. 7C

FIG. 7D

228  222  225

$\vec{j}$

$\vec{k}$ $\odot$ $\vec{i}$

0

231

204  206

202  205

L2

# FIG. 7E

233  235

$\vec{j}$

$\vec{k}$ $\odot$ $\vec{i}$

0

231

$d_1$

202  105

# FIG. 7F

**FIG. 7G**

**FIG. 7H**

253   255

FIG. 7I

253   255

270   280

FIG. 7J

FIG. 8A

FIG. 8B

FIG. 8C

FIG. 8D

FIG. 8E

FIG. 9A

FIG. 9B

353 355

# FIG. 9C

353 355

270 280

# FIG. 9D

FIG. 10A

FIG. 10B

FIG. 10C

453          238          455

          $\vec{j}$

          $\vec{k} \bigodot \xrightarrow{}$
          0      $\vec{i}$

204          206

# FIG. 11A

453  451    454          238          455

          $\vec{j}$

          $\vec{k} \bigodot \xrightarrow{}$
          0      $\vec{i}$

# FIG. 11B

FIG. 11C

FIG. 12A

FIG. 12B

FIG. 13

FIG. 14A

**FIG. 14B**

**FIG. 15A**

700

# FIG. 15B

# FIG. 16

## FIG. 17A

## FIG. 17B

## FIG. 18

# RÉFÉRENCES CITÉES DANS LA DESCRIPTION

**Documents brevets cités dans la description**

- US 20060284239 A1
- US 5757696 A
- US 4435786 A
- US 20030042528 A

**Littérature non-brevet citée dans la description**

- **ASGHAR RAMEZANI et al.** Influence of Van Der Waals Force on the Pull-In Parameters of Cantilever Type Nanoscale Electrostatic Actuators. *Microsystem Technologies,* 2006, vol. 12, 1153-1161
- A Physical Model to Predict Stiction in MEMS. **W. MERLIJN ; VAN SPENGEN et al.** Journal of Micromechanics and Microengineering. Institute of Physics Publishing, 2002, vol. 12, 702-713
- **S. NATARAJAN et al.** Emerging memory technologies - mainstream or hearsay ?. *VLSI Design Automation and Test,* 2005
- **K. TAKEUCHI et al.** A Study of Threshold Voltage Variation for Ultra SmallBulk and SOI CMOS. *IEEE TED,* Septembre 2004, vol. 48 (9
- **M. YAMAOKA et al.** Low Power SRAM Menu for SOC Application Using Yin-Yang-Feedback memory Cell Technology. *Symposium on VLSI circuits, Digest of Technical Papers,* Juin 2004